# EUROPEAN PATENT SPECIFICATION

(11) **EP 3 211 799 B1**
(45) Date of publication and mention of the grant of the patent: **04.12.2019**
(21) Application number: 15852196.3
(22) Date of filing: 07.10.2015
(51) Int. Cl.: H04L 1/00, H04L 27/22

(54) **RECEIVING DEVICE, RECEIVING METHOD FOR RECEIVING DEVICE, AND PROGRAM**
EMPFANGSVORRICHTUNG, EMPFANGSVERFAHREN FÜR EINE EMPFANGSVORRICHTUNG UND PROGRAMM
DISPOSITIF DE RÉCEPTION, PROCÉDÉ DE RÉCEPTION POUR DISPOSITIF DE RÉCEPTION, ET PROGRAMME

(30) Priority: 21.10.2014 JP 2014214212
(43) Date of publication of application: 30.08.2017
(73) Proprietor: Sony Corporation, Tokyo 108-0075 (JP)
(72) Inventor: NAKADA, Yutaka, Tokyo 108-0075 (JP); OKADA, Satoshi, Tokyo 108-0075 (JP); MIZUTANI, Yuichi, Tokyo 108-0075 (JP)
(74) Representative: MFG Patentanwälte Meyer-Wildhagen Meggle-Freund Gerhard PartG mbB
(86) International application number: PCT/JP2015/078496
(87) International publication number: WO 2016/063728

(56) References cited:
- JP-A- 2003 531 550
- JP-A- 2004 304 741
- JP-A- 2010 051 022
- JP-A- 2012 095 110
- JP-A- 2013 251 691
- US-A1- 2011 239 095

## Description

### TECHNICAL FIELD

The present technology relates to a reception device, a reception method on the reception device, and a program, and particularly relates to a reception device, a reception method on the reception device, and a program, capable of enhancing accuracy of repetition decoding system error correction processing.

### BACKGROUND ART

A digital video broadcasting-satellite (DVB-S) satellite digital broadcasting reception device performs demodulation processing on a signal received by an antenna, corrects an error in a result of demodulation processing, and reproduces and outputs an image and sound using the corrected signal.

As a known error correction unit that corrects an error in a signal, there is a proposed art that transforms a signal obtained as a demodulation processing result and represented in a complex plane, into likelihood, performs Viterbi decoding on the likelihood, detects a known signal from the Viterbi-decoded signal and compensates for a signal position in units of code-words, detects a phase shift and spectrum inversion and compensates for them, performs deinterleave processing on the compensated signal, and performs Reed-Solomon (RS) decoding on the deinterleaved signal (refer to Non-Patent Document 1).

In recent years, there is a proposed technology that enhances performance of the error correction unit by performing repetition processing (refer to Non-Patent Document 2 and Patent Document 1). The error correction unit that uses the repetition processing performs, in addition to the above-described processing, interleave processing on the RS-decoded signal as an error correction result, and uses the signal as a feedback signal in Viterbi decoding processing in later signal processing. This processing enhances performance of the error correction unit.

Further examples of reception devices and error correction units thereof are disclosed by Patent Document 2 and Patent Document 3.

### CITATION LIST

### NON-PATENT DOCUMENT

Non-Patent Document 1: ETSI EN 300 421 V1.1.2
Non-Patent Document 2: Y. Narikiyo and M. Takada, "Improvement of HDTV Mobile Reception Performance for ISDB-T Using Iterative Decoding 8-branch Space Diversity Technology," in IEEE International Symposium on Broadband Multimedia Systems and Broadcasting(BMSB 2011), Nurnberg, Germany, June 2011.

### PATENT DOCUMENT

Patent Document 1: Japanese Patent Application Laid-Open No. 2013-251691
Patent Document 2: US 2011/239095 A1
Patent Document 3: JP 2013 251691 A

### SUMMARY OF THE INVENTION

### PROBLEMS TO BE SOLVED BY THE INVENTION

With the error correction unit configured to enhance performance by repetition processing, disclosed in Non-Patent Document 2 and Patent Document 1, however, it is difficult to achieve consistency between a likelihood signal that is a target of Viterbi decoding processing and obtained by likelihood transform performed on the demodulated signal as a main signal, and a feedback signal obtained by interleave processing performed on the error correction result.

That is, while the feedback signal supplies a signal in units of code-words as a result of successful decoding, the main signal cannot allow recognition of which position includes signal sequences in units of code-words. Therefore, in order to enhance accuracy in error correction of the main signal by repetition processing using the feedback signal, there is a need to perform processing by achieving consistency between the main signal and the feedback signal in units of code-words.

The present technology is made in view of this situation and intended to enhance accuracy in the error correction processing using repetition processing by achieving consistency between the main signal and the feedback signal in units of code-words.

### SOLUTIONS TO PROBLEMS

According to a first aspect the invention provides a reception device in accordance with claim 1. According to a second aspect the invention provides a method in accordance with claim 9. Further aspects of the invention are set forth in the dependent claims, the drawings and the following description of embodiments.

A reception device according to one aspect of the present technology includes: a demodulation unit configured to perform demodulation processing on a signal received by an antenna and output a demodulated signal; a first decoding unit configured to decode the demodulated signal to a first decoded signal; a first observation unit configured to observe a known signal included in the first decoded signal and output corresponding compensation information; a first signal compensation unit configured to compensate for the first decoded signal on the basis of the known signal included in the first decoded signal, or to output the first decoded signal without change; a second decoding unit configured to decode the first decoded signal that is compensated by the first signal compensation unit or that is output without change, to a second decoded signal; and a second signal compensation unit configured to compensate for the demodulated signal in a pre-stage of the first decoding unit on the basis of the compensation information from the first observation unit, in which the first decoding unit decodes the demodulated signal compensated by the second signal compensation unit, to the first decoded signal using the second decoded signal, the first signal compensation unit estimates a phase shift and spectrum inversion of the signal on the basis of the known signal included in the first decoded signal and then compensates for the phase shift and spectrum inversion of the first decoded signal, the first observation unit observes the known signal included in the first decoded signal, estimates the phase shift and spectrum inversion of the signal, and then, outputs the corresponding compensation information, and the second signal compensation unit compensates for the phase shift and spectrum inversion of the first decoded signal of the demodulated signal in a pre-stage of the first decoding unit on the basis of the compensation information from the first observation unit.

It is possible to configure to further include a likelihood transform unit configured to transform the demodulated signal into likelihood, and possible to cause the second signal compensation unit to compensate for the phase shift and spectrum inversion of the first decoded signal of the demodulated signal, in a pre-stage of the likelihood transform unit and the first decoding unit on the basis of the compensation information from the first observation unit.

It is possible to configure to further include a likelihood transform unit configured to transform the demodulated signal into likelihood, and possible to cause the second signal compensation unit to compensate for the phase shift and spectrum inversion of the first decoded signal of the likelihood obtained by transforming the demodulated signal, in a post-stage of the likelihood transform unit and in a pre-stage of the first decoding unit on the basis of the compensation information from the first observation unit.

It is possible to configure to further include: a third signal compensation unit configured, on the basis of the known signal included in the first decoded signal, to estimate a frame configuration of the signal and to compensate for the first decoded signal; a second observation unit configured to observe the known signal included in the first decoded signal, estimate a frame configuration of the signal, and output corresponding compensation information; and a fourth signal compensation unit configured to compensate for the demodulated signal in a pre-stage of the first decoding unit on the basis of the compensation information as an observation result of the second observation unit.

It is possible to cause the third signal compensation unit to compensate for the first decoded signal in a pre-stage of the first signal compensation unit, and to cause the fourth signal compensation unit to compensate for the demodulated signal in a pre-stage of the second signal compensation unit.

It is possible to cause the third signal compensation unit to compensate for the first decoded signal in a post-stage of the first signal compensation unit, and to cause the fourth signal compensation unit to compensate for the demodulated signal in a post-stage of the second signal compensation unit.

It is possible to cause the first decoding unit to decode the demodulated signal to the first decoded signal by Viterbi decoding.

It is possible to cause the second decoding unit to decode the first decoded signal compensated by the first signal compensation unit, to the second decoded signal, using Read-Solomon (RS) decoding.

A receiving method on a reception device, according to one aspect of the present technology includes the steps of: performing demodulation processing on a signal received by an antenna and outputting a demodulated signal; decoding the demodulated signal to a first decoded signal; observing a known signal included in the first decoded signal and outputting corresponding compensation information; compensating for the first decoded signal on the basis of the known signal included in the first decoded signal, or outputting the first decoded signal without change; decoding the first decoded signal that is compensated by the first signal compensation unit or that is output without change, to a second decoded signal; and compensating for the demodulated signal in a pre-stage of the first decoding unit on the basis of the compensation information from the first observation unit, in which processing in the step of decoding the first decoded signal decodes the demodulated signal compensated by the second signal compensation unit, to the first decoded signal using the second decoded signal, processing in a step of compensating for a phase shift and spectrum inversion of the first decoded signal estimates the phase shift and spectrum inversion of the signal on the basis of the known signal included in the first decoded signal and then compensates for the phase shift and spectrum inversion of the first decoded signal, processing in a step of outputting the compensation information estimates the phase shift and spectrum inversion of the first decoded signal, and then, outputs the corresponding compensation information, and processing in a step of compensating for the phase shift and spectrum inversion of the first decoded signal compensates for the phase shift and spectrum inversion of the first decoded signal of the demodulated signal in a pre-stage of the first decoding unit on the basis of the compensation information from the first observation unit.

A program according to one aspect of the present technology causes a computer to achieve a configuration including: a demodulation unit configured to perform demodulation processing on a signal received by an antenna and output a demodulated signal; a first decoding unit configured to decode the demodulated signal to a first decoded signal; a first observation unit configured to observe a known signal included in the first decoded signal and output corresponding compensation information; a first signal compensation unit configured to compensate for the first decoded signal on the basis of the known signal included in the first decoded signal, or to output the first decoded signal without change; a second decoding unit configured to decode the first decoded signal that is compensated by the first signal compensation unit or that is output without change, to a second decoded signal; and a second signal compensation unit configured to compensate for the demodulated signal in a pre-stage of the first decoding unit on the basis of the compensation information from the first observation unit, in which the first decoding unit decodes the demodulated signal compensated by the second signal compensation unit, to the first decoded signal using the second decoded signal, the first signal compensation unit estimates a phase shift and spectrum inversion of the signal on the basis of the known signal included in the first decoded signal and then compensates for the phase shift and spectrum inversion of the first decoded signal,
the first observation unit observes the known signal included in the first decoded signal, estimates the phase shift and spectrum inversion of the signal, and then, outputs the corresponding compensation information, and the second signal compensation unit compensates for the phase shift and spectrum inversion of the first decoded signal of the demodulated signal in a pre-stage of the first decoding unit on the basis of the compensation information from the first observation unit.

According to one aspect of the present technology, a signal received by an antenna undergoes demodulation processing, a demodulated signal is output, the demodulated signal is decoded to a first decoded signal, a known signal included in the first decoded signal is observed, corresponding compensation information is output, the first decoded signal is compensated on the basis of the known signal included in the first decoded signal or the first decoded signal is output without change, the first decoded signal that is compensated by the first signal compensation unit or that is output without change is decoded to a second decoded signal, the demodulated signal is compensated in a pre-stage of being decoded to the first decoding signal on the basis of the compensation information, the demodulated signal that is compensated is decoded to the first decoded signal using the second decoded signal, a phase shift and spectrum inversion of the signal is estimated on the basis of the known signal included in the first decoded signal and then the phase shift and spectrum inversion of the first decoded signal are compensated, the known signal included in the first decoded signal is observed, the phase shift and spectrum inversion of the signal are estimated, then, the corresponding compensation information is output, and the phase shift and spectrum inversion of the first decoded signal of the demodulated signal are compensated in a pre-stage of being decoded to the first decoded signal on the basis of the compensation information.

A reception device according to one aspect of the present technology may be a separate device or a block that functions as each of the receiving devices.

### EFFECTS OF THE INVENTION

According to one aspect of the present technology, it is possible to achieve error correction with higher accuracy in repetition-system error correction processing.

### BRIEF DESCRIPTION OF DRAWINGS

Fig. 1 is a diagram illustrating an exemplary configuration of a reception device to which the present technology is applied.
Fig. 2 is a diagram illustrating an exemplary configuration of a typical error correction unit.
Fig. 3 is a diagram illustrating an exemplary configuration of another typical error correction unit.
Fig. 4 is a diagram illustrating an exemplary configuration of an error correction unit to which the present technology is applied, according to a first embodiment.
Fig. 5 is a diagram illustrating exemplary estimation of a frame configuration from a known signal.
Fig. 6 is a flowchart illustrating error correction processing by the error correction processing in Fig. 4.
Fig. 7 is a flowchart illustrating position observation processing in Fig. 6.
Fig. 8 is a diagram illustrating operation performed by an observation unit.
Fig. 9 is a diagram illustrating operation of signal compensation unit.
Fig. 10 is a diagram illustrating a phase shift and spectrum inversion.
Fig. 11 is a diagram illustrating an exemplary configuration of an error correction unit to which the present technology is applied, according to a second embodiment.
Fig. 12 is a flowchart illustrating error correction processing by the error correction unit in Fig. 11.
Fig. 13 is a flowchart illustrating phase observation processing in Fig. 12.
Fig. 14 is a diagram illustrating phase observation processing.
Fig. 15 is a diagram illustrating an exemplary configuration of an error correction unit to which the present technology is applied, according to a third embodiment.
Fig. 16 is a flowchart illustrating error correction processing by the error correction unit in Fig. 15.
Fig. 17 is a diagram illustrating error correction processing by the error correction unit in Fig. 15.
Fig. 18 is a diagram illustrating error correction processing by the error correction unit in Fig. 15.
Fig. 19 is a diagram illustrating an exemplary configuration of an error correction unit to which the present technology is applied, according to a fourth embodiment.
Fig. 20 is a flowchart illustrating error correction processing by the error correction unit in Fig. 19.
Fig. 21 is a diagram illustrating an exemplary configuration of a general-purpose personal computer.

### MODE FOR CARRYING OUT THE INVENTION

### <Exemplary configuration of reception device>

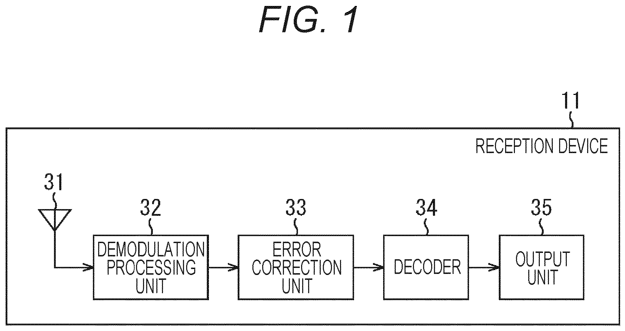

Fig. 1 illustrates an exemplary configuration of a reception device to which the present technology is applied.

A reception device 11 illustrated in FIG. 1 is a known digital video broadcasting-satellite (DVB-S) reception device.

The reception device 11 includes an antenna 31, a demodulation processing unit 32, an error correction unit 33, a decoder 34, and an output unit 35.

The demodulation processing unit 32 receives a signal from a satellite via the antenna 31, performs demodulation processing on the signal, and supplies the processed signal to the error correction unit 33. The error correction unit 33 decodes a demodulation-processed signal from a satellite, that has undergone convolutional encoding processing as an inner signal and undergone Read-Solomon (RS) encoding processing as an outer signal, performs error correction processing on this signal, and outputs the processed signal to the decoder 34.

The decoder 34 performs decode processing on the basis of the error-corrected signal, and outputs a result of decoding from the output unit 35, as an image or sound.

### <Exemplary configuration of typical error correction unit>

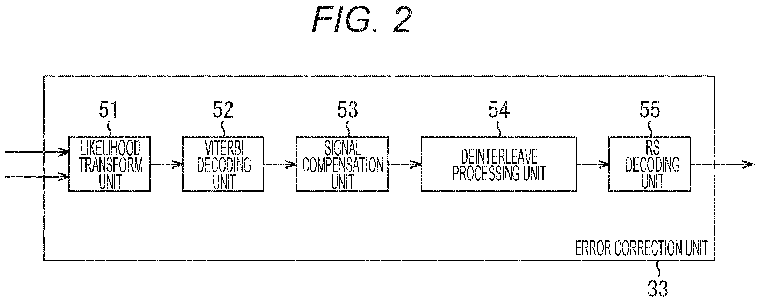

Before describing an exemplary configuration of the error correction unit to which the present technology is applied, an exemplary configuration of a typical error correction unit will initially be described with reference to Fig. 2.

The typical error correction unit 33 in Fig. 2 includes a likelihood transform unit 51, a Viterbi decoding unit 52, a signal compensation unit 53, a deinterleave processing unit 54, and an RS decoding unit 55.

The likelihood transform unit 51 transforms a signal, as a demodulation processing result, that is, the signal including an I-signal and a Q-signal, represented on a complex plane, into likelihood, and outputs the likelihood onto the Viterbi decoding unit 52. At this time, for example, the likelihood has a binarized signal sequence, represented by likelihood 1, and likelihood 2, for example.

The Viterbi decoding unit 52 performs Viterbi decoding on the likelihood that is a convolutionally encoded signal as an inner signal, supplied from the likelihood transform unit 51, and outputs the Viterbi-decoded signal onto the signal compensation unit 53.

The signal compensation unit 53 detects, from among the Viterbi-decoded signals, a known signal such as one of 0x47 and 0xB8, known as a synchronization signal, estimates and compensates for the length and position, in units of code-words constituting a frame. Together with this, the signal compensation unit 53 detects and compensates for the phase shift and spectrum inversion, and outputs the compensated signal to the deinterleave processing unit 54.

The deinterleave processing unit 54 performs deinterleave processing on the compensated signal and outputs the processed signal to the RS decoding unit 55.

The Read-Solomon (RS) decoding unit 55 decodes RS-encoded signal, as an outer signal, that has undergone deinterleave processing by the deinterleave processing unit 54, and outputs the decoded signal as an error correction result.

In short, error correction is performed in such a manner that the signal obtained as likelihood is Viterbi-decoded, and a known signal is detected, whereby the frame length and position as a unit of code-word are estimated and compensated, and together with this, phase shift and spectrum inversion are compensated, and then, the signal is deinterleaved and thereafter RS-decoded.

### <Exemplary configuration of error correction unit using repetition processing>

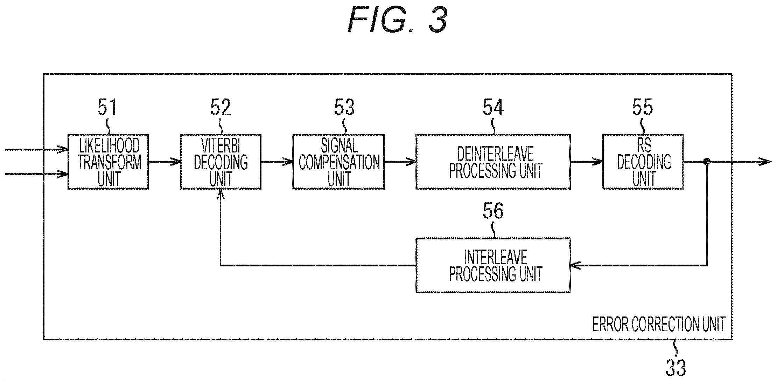

In recent years, there is a proposed technology that enhances performance of error correction by repetition processing. Fig. 3 illustrates an exemplary configuration of another typical error correction unit 33, using this repetition processing.

In the exemplary configuration of the error correction unit 33 in Fig. 3, same names and reference signs are given to the configuration having functions same as the functions of the error correction unit in Fig. 2, and description therefor will be omitted as appropriate.

That is, the difference in the error correction unit 33 in Fig. 3 from the error correction unit 33 in Fig. 2 is that there is an interleave processing unit 56 additionally provided to perform interleave processing on the output of the RS decoding unit 55.

The interleave processing unit 56 performs interleave processing on the output of the RS decoding unit 55 and supplies a processing result to the Viterbi decoding unit 52.

At this time, in the second or later processing, the Viterbi decoding unit 52 performs decoding processing using a feedback signal for which RS decoding is successful, supplied from the interleave processing unit 56. Note that for details of processing of Viterbi decoding on the main signal using the feedback signal for which RS decoding is successful, refer to Non-Patent Document 2, Patent Document 1, or the like.

Meanwhile, the feedback signal for which RS decoding is successful is a signal formed in units of code-words, that has undergone, on the signal compensation unit 53, compensation based on the estimation of the length and position in units of frames (units of code-words) based on a known signal, and compensation for the phase shift and spectrum inversion. In contrast, the signal supplied from the likelihood transform unit 51 to the Viterbi decoding unit 52 is a signal for which the position in units of frames (units of code-words) has not been confirmed, or compensation for the phase shift and spectrum inversion has not been performed, and thus, for which how the units of code-words are arranged is not known. Therefore, performing decoding processing by the Viterbi decoding unit 52 on the basis of the feedback signal without change in an order of signals supplied from the likelihood transform unit 51 might lead to inconsistency and a possibility of failure in achieving accuracy.

### <Exemplary configuration of error correction unit to which present technology is applied, according to a first embodiment>

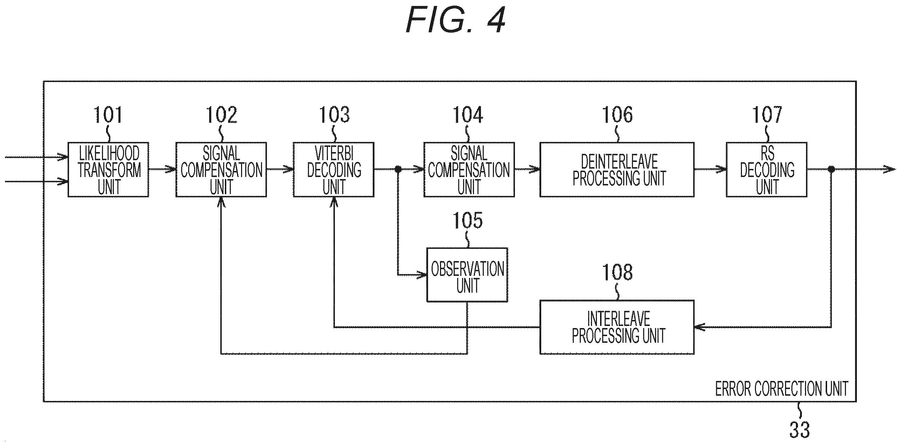

Next, an exemplary configuration of the error correction unit 33 to which the present technology is applied, according to the first embodiment, will be described with reference to Fig. 4.

Specifically, the error correction unit 33 in Fig. 4 includes a likelihood transform unit 101, a signal compensation unit 102, a Viterbi decoding unit 103, a signal compensation unit 104, an observation unit 105, a deinterleave processing unit 106, an RS decoding unit 107, and an interleave processing unit 108.

Note that fundamental functions of the likelihood transform unit 101, the Viterbi decoding unit 103, the signal compensation unit 104, the deinterleave processing unit 106, the RS decoding unit 107, and the interleave processing unit 108 are similar to the fundamental functions of the likelihood transform unit 51, the Viterbi decoding unit 52, the signal compensation unit 53, the deinterleave processing unit 54, the RS decoding unit 55, and the interleave processing unit 56, respectively, and thus, description will be omitted as appropriate. Moreover, herein, the signal compensation unit 104 detects a known signal, estimates the configuration of the frames, compensates for the position of the signal to be processed in accordance with the estimated configuration, and supplies the signal in units of code-words to the deinterleave processing unit 106.

The observation unit 105 estimates the configuration such as the position and length in the units of frames (units of code-words) by observing the information on the position of the known signal, and obtains the amount of compensation for the position to be performed on the signal compensation unit 104 on the basis of the estimation result, then, supplies the amount to the signal compensation unit 102, as positional compensation information as an observation result.

The signal compensation unit 102 compensates for the position of the signal output from the likelihood transform unit 51 on the basis of the positional compensation information supplied from the observation unit 105, thereby outputting the signal in units of code-words to the Viterbi decoding unit 103.

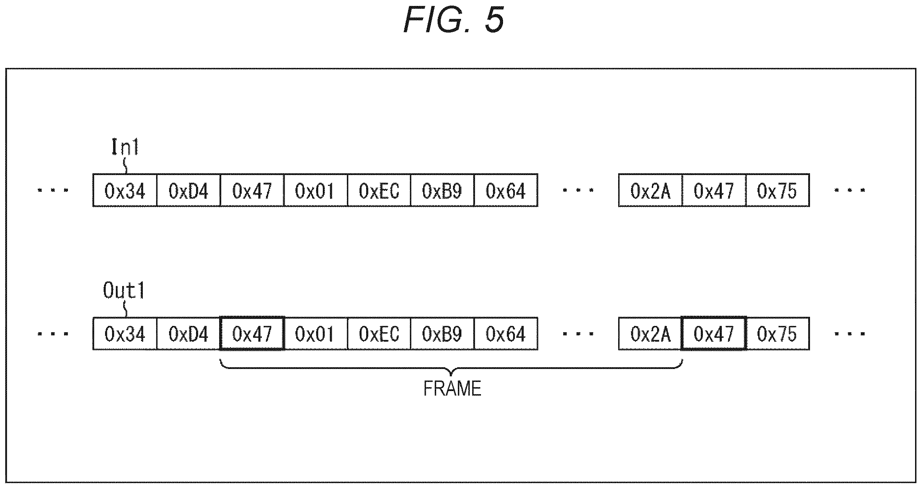

That is, as illustrated with an output signal Out1 in a lower portion of Fig. 5 when an input signal In1 is supplied as illustrated in an upper portion of Fig. 5, the signal compensation unit 104 detects one of known values 0x47 and 0xB8, that is, values of synchronous bytes provided at a final position of a packet, defined in the Digital Video Broadcasting-Terrestrial (ISDB-T) standard. Then, on the basis of the position of units of bytes of the one of the known values 0x47 and 0xB8, the signal compensation unit 104 compensates for the position such that, for example, a predetermined value of 204 bytes becomes signals for one frame, and then, sequentially outputs the signals in suitable units of code-words such as the unit of one frame, onto the RS decoding unit 107.

As a result, the RS decoding unit 107 can properly perform RS decoding by decoding the information of 204 bytes from the head position of the signals for one frame.

Moreover, compensation information needed for compensation of the position performed by the above-described signal compensation unit 104 is supplied from the observation unit 105 to the signal compensation unit 102. As a result, the signal compensation unit 102 can compensate for the position shift that is similar to the case of the signal compensation unit 104. Then, this process enables proper supply of the likelihood-transformed signal, in units of code-words, from the signal compensation unit 102 to the Viterbi decoding unit 103 so as to be properly consistent with the RS decoding result by the RS decoding unit 107 in a post-stage. As a result, this enables the Viterbi decoding unit 103 to properly perform Viterbi decoding on the main signal supplied from the signal compensation unit 102, on the basis of the feedback signal for which RS decoding is successful by the RS decoding unit 107 and a result of output for which has been interleave-processed by the interleave processing unit 108.

That is, repetition processing makes it possible to effectively enhance accuracy of error correction.

### <Error correction processing by error correction unit in Fig. 4>

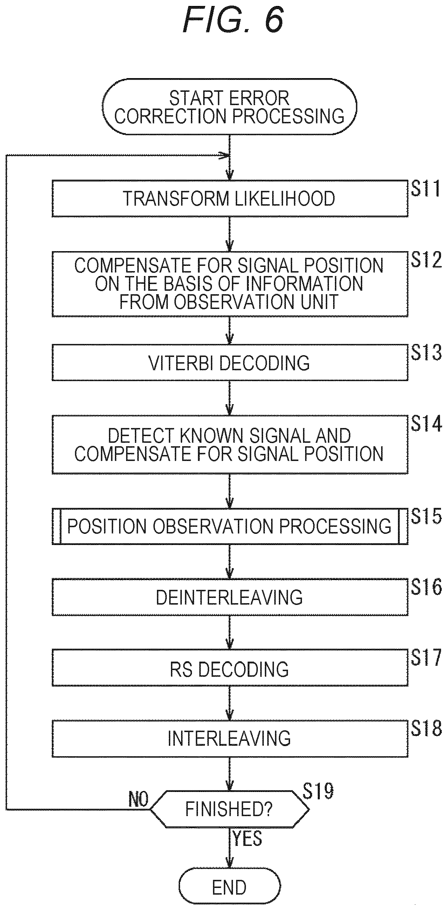

Next, error correction processing performed by the error correction unit 33 in Fig. 4 will be described with reference to the flowchart in Fig. 6.

In step S11, the likelihood transform unit 101 transforms the signal, as a demodulation processing result from the demodulation processing unit 32, represented on a complex plane, into likelihood, and outputs the likelihood onto the signal compensation unit 102.

In step S12, the signal compensation unit 102 compensates for the position of the signal of likelihood on the basis of the amount of compensation as the observation result from the observation unit 105, based on information on previous input signal stream so as to be able to be processed in units of code-words on a proper frame, and outputs the compensated signal to the Viterbi decoding unit 103. Note that, however, the correct frame position is not specified for the head frame, and thus, proper processing is not possible in units of code-words. Accordingly, processing is assumed to be performed using a provisional frame length. Furthermore, on the observation unit 105, information on the amount of compensation as an observation result is not transmitted until a known signal is detected by the processing to be described below. Accordingly, the signal is output without change, that is, with no compensation, or the like, performed on the signal.

In step S13, the Viterbi decoding unit 103 performs Viterbi decoding on the compensated likelihood signal and outputs the decoded signal to the signal compensation unit 104 and the observation unit 105. At this time, initial processing is in a state where the feedback signal for which RS decoding is successful by the RS decoding unit 107 is not supplied. Accordingly, processing is performed by typical Viterbi transform in the initial processing.

In step S14, the signal compensation unit 104 detects a known signal among the Viterbi-decoded signals, detects known signals including detected synchronous signals such as one of 0x47 and 0xB8, inputs blank signals for predetermined bytes immediately before the detected known signal, and thereafter, sequentially outputs the signals in units of code-words for one frame from the head, onto the deinterleave processing unit 106.

In step S15, the observation unit 105 executes position observation processing, and thereby observing the information on the position to be compensated as the head position for one frame in units of code-words, to be compensated by the signal compensation unit 104, and supplies the information on the amount of shift to be a difference for that position, to the signal compensation unit 102 as compensation information.

### <Position observation processing >

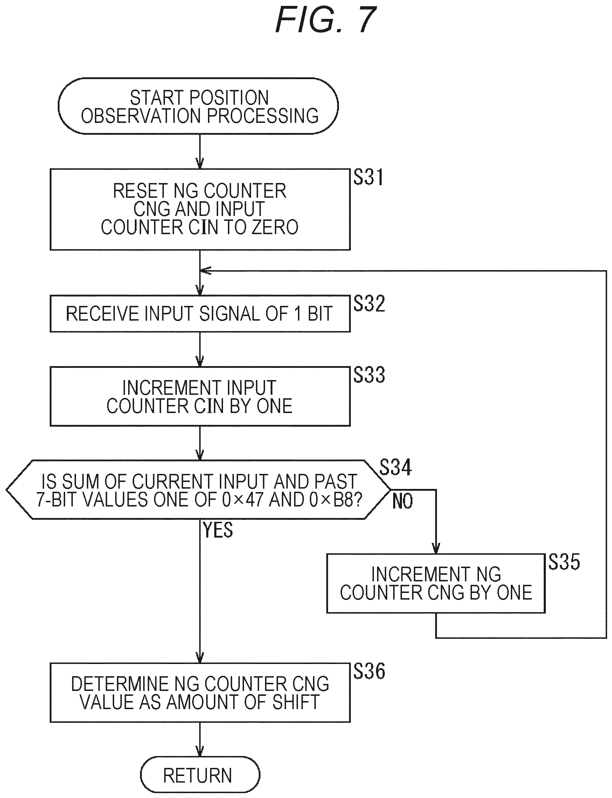

Now, position observation processing performed by the observation unit 105 will be described with reference to the flowchart in Fig. 7.

In step S31, the observation unit 105 resets an NG counter CNG, and an input counter CINDY. The NG counter CNG counts the number of signals in a case where the signal is not a known signal. The input counter CINDY counts the number of input signals.

In step S32, the observation unit 105 receives an input signal for one bit (1bit).

In step S33, the observation unit 105 increments an input counter CIN by one.

In step S34, the observation unit 105 determines whether the signal of eight bits in total, that is, the sum of the current input signal and the past seven-bit values is one of the known signals 0x47 and 0xB8. In step S34, in a case, for example, where the signal of eight bits in total, that is, the sum of the current input signal and the past seven-bit values is not any of the known signals 0x47 and 0xB8, the processing proceeds to step S35.

In step S35, the observation unit 105 increments the NG counter CNG by one, and the processing returns to step S32. Then, for example, the processing in steps S32 to S35 is repeated until the signal of eight bits in total, that is, the sum of the current input signal and the past seven-bit values becomes one of the known signals 0x47 and 0xB8.

Subsequently, in step S34, in a case, for example, where the signal of eight bits in total, that is, the sum of the current input signal and the past seven-bit values is one of the known signals 0x47 and 0xB8, the processing proceeds to step S36.

In step S36, the observation unit 105 transmits the value of the NG counter CNG, as the amount of shift, to the signal compensation unit 102.

With the above-described processing, by detecting the position where one of the known signals 0x47 and 0xB8 is detected, the amount of shift between the head position of the frame and the head position of a provisional frame is to going be obtained as the amount of compensation.

Now, the flowchart in Fig. 6 will be described again.

In step S16, the deinterleave processing unit 106 performs deinterleave processing on the signal position-compensated by the signal compensation unit 104 and supplies the processed signal to an RS processing unit 107.

In step S17, the RS processing unit 107 decodes the deinterleaved signal by performing RS decoding processing thereon, and outputs the decoded signal as an error correction result, and together with this, supplies the decoded signal to the interleave processing unit 108.

In step S18, the interleave processing unit 108 interleaves the output as the error correction result, and supplies the interleaved output to the Viterbi decoding unit 103.

In step S19, the likelihood transform unit 101 determines whether the input signal is finished. In a case where it is not finished, the processing returns to step S11, and subsequent processing is repeated. Subsequently, in a case where step S19 determines that the input signal is finished, the processing is finished.

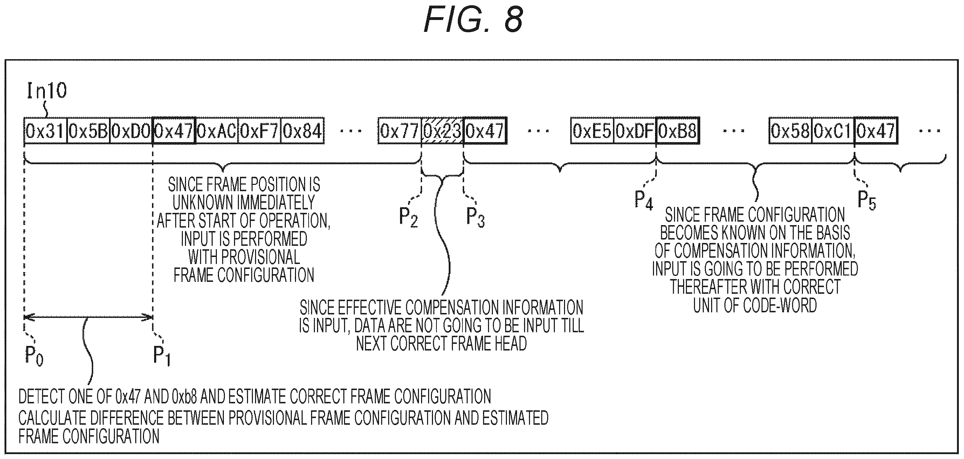

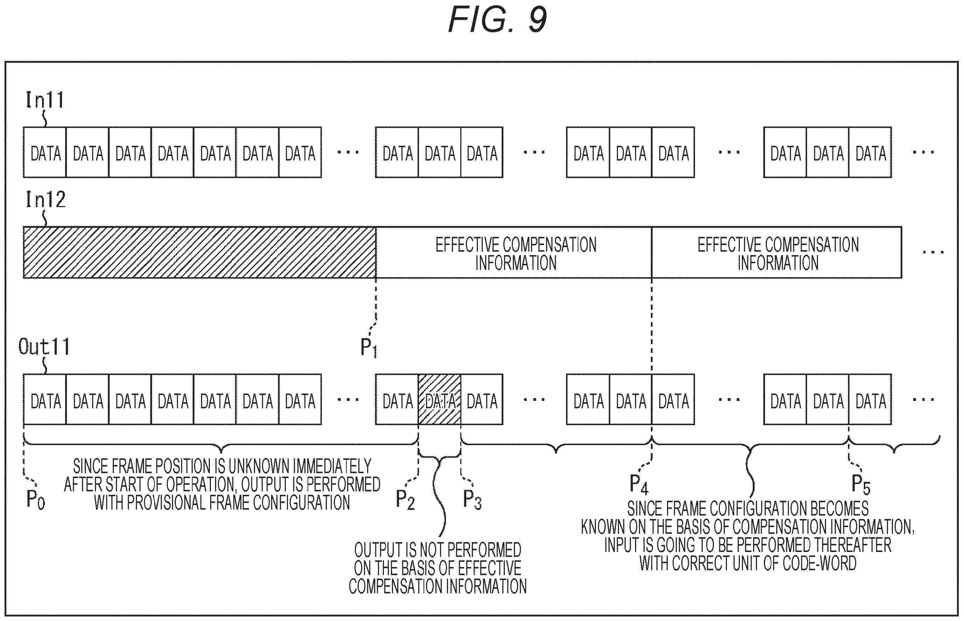

For example, with the above-described processing, an input signal stream In10 as illustrated in Fig. 8 is input at the signal compensation unit 104 and the observation unit 105. At this time, an input signal stream In11 as illustrated in Fig. 9 is input also at the signal compensation unit 102 in the timing before input is performed at the signal compensation unit 104 and the observation unit 105. Note that the data are assumed to be in units of 26 bytes, in Figs. 8 and 9. Moreover, it is assumed that input is performed such that 0x31, 0x5B, 0xD0, 0x47, 0xAC, 0x84 ···, sequentially from the left side of Fig. 8. Note that data in units of bytes are not read at the signal compensation unit 102 for the input signal In11 in Fig. 9. Accordingly, merely "data" is used for description instead of distinguished data such as 0x31, 0x5B, 0xD0, 0x47, 0xAC, and 0x84. In other words, the signal compensation unit 102 does not read the position by the information of input signal sequence. Note that the input signal sequences In10 and In11 in Figs. 8 and 9 are substantially identical.

At this time, known data are detected sequentially in a unit of one bit from the head data by the position observation processing in step S15. Subsequently, the known data 0x47 indicated at the fourth position from the left in Fig. 8 are detected, the number of bits from the head position P0 to a head position P1 of the data 0x47 is counted as an NG count CNG, so as to be obtained as the amount of shift, as a difference. Accordingly, as illustrated in Fig. 8, the observation unit 105 transmits, as compensation information, the amount of shift between the head position of the original frame and the data currently transmitted to the head, that is, the difference between a current head position P0 on a provisional frame and the head position P1 of the known data 0x47, to the signal compensation unit 102. That is, effective compensation information that corresponds to, for example, the amount of shift for 26 bytes in this example is transmitted to the signal compensation unit 102 in a timing of reception of the head position P1.

Accordingly, as indicated by a signal sequence In12 of the compensation information in Fig. 9, the signal compensation unit 102 receives compensation information that is effective (effective compensation information) indicating the amount of shift from the data currently transmitted to the head, in the timing of reception of data in the positions P1 to P4.

Subsequently, on the basis of the effective compensation information, the signal compensation unit 102 stops output of signals of the number of bits corresponding to the amount of shift, as indicated by the positions P2 to P3 in an output signal sequence Out11 in Fig. 9, and thereafter, outputs the position-compensated signal for one frame in the positions P3 to P4. That is, since the signal compensation unit 102 does not recognize signals, it cannot recognize the position in units of code-words. However, the signal compensation unit 102 compensates for the amount of shift at the head position in units of code-words by stopping the signal output for the number of bits corresponding to the amount of shift on the basis of compensation information from the observation unit 105.

Accordingly, as indicated by the positions P2 to P3 in the input signal sequence In10 in Fig. 8, data is not input either in the signal compensation unit 104 or the observation unit 105, and thereafter, data for the positions P3 to P4 are sequentially input.

Subsequently on the position P4 or later, as indicated by the output signal sequence Out11 in Fig. 9, the signal compensation unit 102 continues to output the output signal sequence Out11 consecutively in a state where position compensation in units of code-words is completed. As a result, as indicated by the input signal sequence In11 in Fig. 9, one of the known signals of 0x47 and 0xB8 is constantly received at the head position in units of code-words. Accordingly, thereafter, the amount of shift becomes zero. Since the position has been compensated at the position P4 or later, as indicated by the input signal sequence In11 in Fig. 9, the amount of shift in the effective compensation information supplied from the observation unit 105 to the signal compensation unit 102 becomes zero. As a result, in the positions P4 to P5, the position shift in units of code-words is compensated such that a signal for one frame is output properly from the head position, onto the observation unit 105, as indicated by the input signal sequence In10 in Fig. 8.

With this configuration, thereafter, it is possible to input both the input signal that is going to be processed by the Viterbi decoding unit 103, and the feedback signal to be referred to in processing, supplied from the interleave processing unit 108, in a state where proper consistency is achieved in units of frames, namely, in units of code-words.

As a result, while the earlier repetition processing needed to separately provide the error correction unit in parallel, there is no need to mount the error correction unit in parallel. Accordingly, it is possible to reduce the area for mounting the error correction unit in parallel and to reduce the mounting cost.

### <Exemplary configuration of error correction unit to which present technology is applied, according to second embodiment>

The above section has described an exemplary case where accuracy of error correction processing using repetition processing is enhanced by achieving proper consistency in units of frames (units of code-words) between the input signal stream and the feedback signal on the Viterbi decoding unit 103 by compensating for the frame position of the input signal stream.

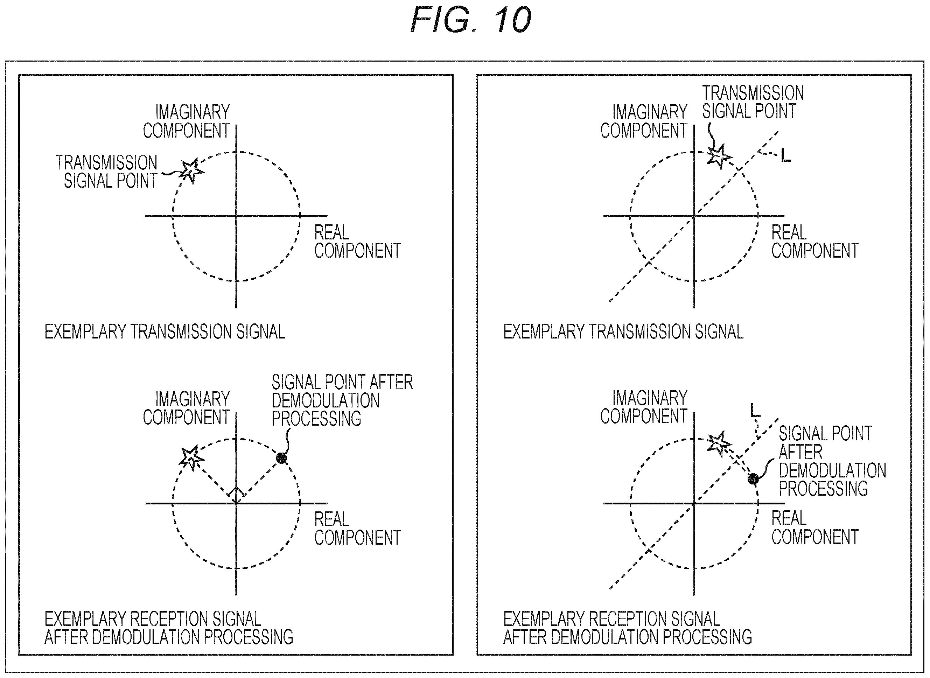

Meanwhile, the input signal stream on the demodulation processing unit 32 might include phase shifts of 90, 180, and 270 degrees with respect to the transmission signal, on the complex plane. That is, as illustrated in a left portion of Fig. 10, in a case where the signal indicated by a star is a transmission signal, a phase shift of 90 degrees might occur in reception due to demodulation processing and then, a signal might be received as a received signal indicated by a filled circle. Note that, in Fig. 10, the horizontal axis indicates a real component as the I-signal, and the vertical axis indicates an imaginary component as the Q-signal.

Moreover, there might be a case where the spectrum of a received wave is inverted on the antenna 31, leading to switching and inversion of the I-signal and the Q-signal with each other. That is, as illustrated in a right portion of Fig. 10, in a case where the signal indicated by a star is a transmission signal, when spectrum inversion is generated on reception due to demodulation processing, this might lead to inversion about the axis of a line L (line on which real component = imaginary component) and lead to reception as a received signal indicated by the filled circle.

Accordingly, it is also allowable to configure to enhance accuracy in error correction processing with repetition processing by observing and compensating for such phase shift and spectrum inversion.

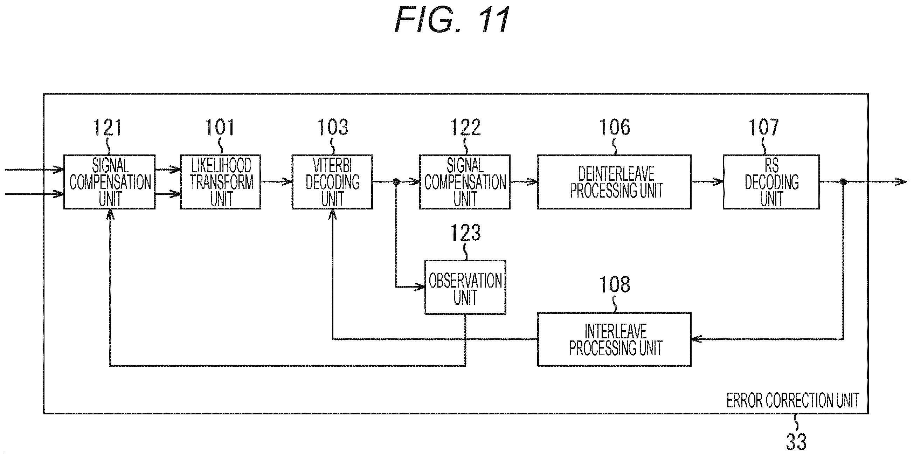

Fig. 11 is an exemplary configuration of the error correction unit 33 configured to enhance accuracy in error correction processing with repetition processing by observing and compensating for such phase shift and spectrum inversion. Note that, in the error correction unit 33 in Fig. 11, same names and reference signs are given to the configuration having functions same as the functions of the error correction unit 33 n Fig. 4, and description therefor will be omitted as appropriate.

Specifically, differences in the error correction unit 33 in Fig. 11 from the error correction unit 33 in Fig. 4 are that there are a signal compensation unit 121, a signal compensation unit 122, and an observation unit 123 instead of the signal compensation unit 102, the signal compensation unit 104, and the observation unit 105, and furthermore, that the signal compensation unit 121 is arranged in a pre-stage of the likelihood transform unit 101.

On the basis of compensation information in accordance with the observation result of phase shift and spectrum inversion, obtained from the observation unit 123, the signal compensation unit 121 compensates for the phase shift and spectrum inversion of the I-signal and the Q-signal, input from the demodulation processing unit 32, and supplies the compensated signal to the likelihood transform unit 101.

The signal compensation unit 122 detects a phase shift and spectrum inversion on the basis of the Viterbi-decoded signal output from the Viterbi decoding unit 103, compensates for the signal on the basis of the detection result, and outputs the compensated signal to the deinterleave processing unit 106.

The observation unit 123 observes the phase shift and spectrum inversion on the basis of the Viterbi-decoded signal output from the Viterbi decoding unit 103 and supplies the observation result with presence or absence of phase shift and spectrum inversion as compensation information, to the signal compensation unit 121.

### <Error correction processing by error correction unit in Fig. 11>

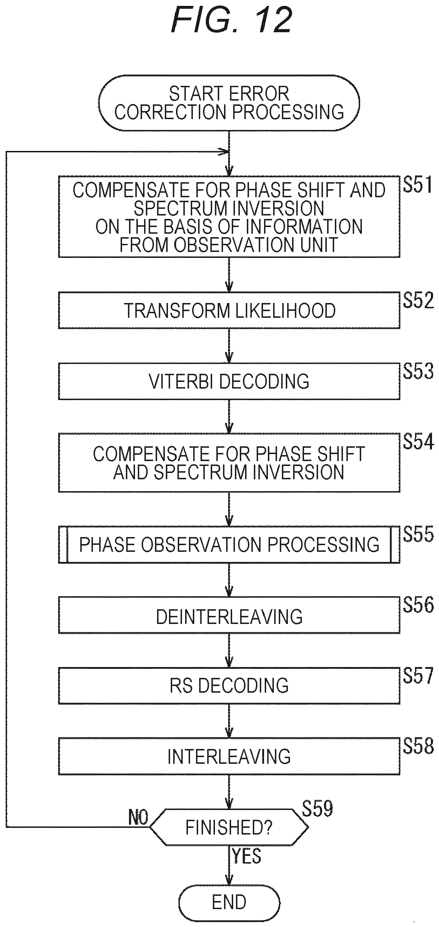

Next, error correction processing performed by the error correction unit 33 in Fig. 11 will be described with reference to the flowchart in Fig. 12. Note that processing in steps S52 to S54, and processing in steps S56 to S59, illustrated in Fig. 12, are similar to the processing in steps S11, S13, and S14, and processing in steps S16 to S19, illustrated in Fig. 6. Accordingly, description therefor will be omitted.

Specifically, in step S51, the signal compensation unit 121 compensates for the I-signal and the Q-signal supplied from the demodulation processing unit 32 on the basis of the compensation information indicating presence or absence of phase shift and presence or absence of spectrum inversion as observation results, based on preceding input signal stream information that is supplied from the observation unit 123, and outputs the compensated signals to the likelihood transform unit 101. Note that the compensation information supplied from the observation unit 123 merely indicates the presence or absence of phase shift and spectrum inversion, and thus, does not include information on the angle of the phase shift or the angle of the spectrum inversion. Therefore, every time the compensation information indicating the generation of the phase shift and the spectrum inversion is transmitted, the signal compensation unit 121 performs compensation for the phase shift of each of 90, 180, and 270 degrees, and compensation for spectrum inversion toward each of the phase shifts, in a manner to switch between each other cyclically. With this configuration, by repeating compensation while switching the compensation content until information indicating the generation of the phase shift and spectrum inversion is no longer transmitted as compensation information, the compensation is going to be performed at least in any of the patterns.

Subsequently, using processing in steps S52 to S54, the signal is transformed into the likelihood by the likelihood transform unit 101, then Viterbi-decoded by the Viterbi decoding unit 103, and further, presence or absence of phase or spectrum inversion is detected by the signal compensation unit 122, and in a case where one of these is detected, corresponding compensation is performed.

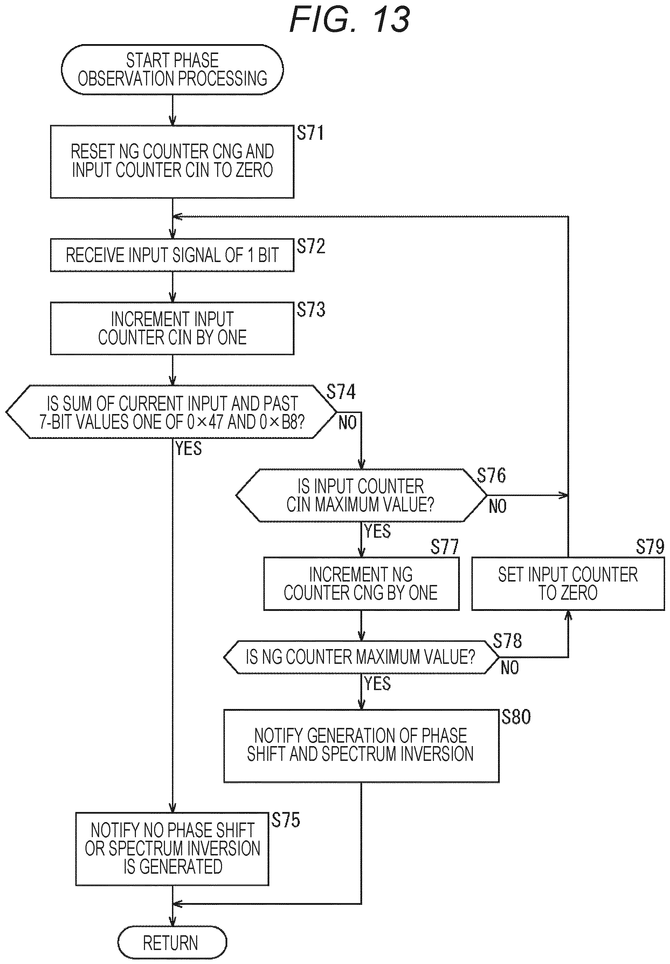

In step S55, the observation unit 123 executes phase observation processing, determines whether a phase shift or spectrum inversion is generated, and notifies corresponding compensation information to the signal compensation unit 121. Note that the phase observation processing will be described in detail below, with reference to the flowchart in Fig. 13.

In steps S56 to S59, interleave processing is performed by the deinterleave processing unit 106, output is performed after RS decoding processing is performed by the RS decoding unit 107, and together with this, interleave processing is performed by the interleave processing unit 108. Similar processing is repeated until no signal is supplied from the demodulation processing unit 32.

### <Phase observation processing>

Now, phase observation processing performed by the observation unit 123 in Fig. 11 will be described with reference to the flowchart in Fig. 13.

In step S71, the observation unit 123 resets the NG counter CNG, and the input counter CIN. The NG counter CNG counts the number of signals in a case where the signal is not a known signal. The input counter CIN counts the number of input signals.

In step S72, the observation unit 123 receives an input signal for one bit (1bit).

In step S73, the observation unit 123 increments the input counter CIN by one.

In step S74, the observation unit 123 determines whether the signal of eight bits in total, that is, the sum of the current input signal and the past seven-bit values is one of the known signals 0x47 and 0xB8. In step S74, in a case, for example, where the signal of eight bits in total, that is, the sum of the current input signal and the past seven-bit values is determined to be one of the known signals 0x47 and 0xB8, the processing proceeds to step S75.

In step S75, the observation unit 123 notifies an observation result indicating that no phase shift or spectrum inversion is generated, to the signal compensation unit 121 as compensation information.

In contrast, in step S74, in a case, for example, where the signal of eight bits in total, that is, the sum of the current input signal and the past seven-bit values is determined not to be any of the known signals 0x47 and 0xB8, the processing proceeds to step S76.

In step S76, the observation unit 123 determines whether the input counter CIN indicates a maxim value. In a case it is not the maxim value, processing returns to step S72 and subsequent processing is repeated.

Moreover, in a case where, in step S76, the input counter CIN is determined to indicate the maximum value, that is, in a case, for example, where the signal of eight bits in total, that is, the sum of the current input signal and the past seven-bit values is determined not to be any of the known signals 0x47 and 0xB8, and the input counter CIN is repeated, for example, until the value becomes the maximum value corresponding to the code length defined as the frame length, the processing proceeds to step S77.

In step S77, the observation unit 123 increments the NG counter CNG by one and the processing proceeds to step S78.

In step S78, the observation unit 123 determines whether the NG counter CNG indicates a maximum value. In case it is not the maximum value, the processing proceeds to step S79.

In step S79, the observation unit 123 resets the NG counter CNG to zero and processing returns to step S72.

Subsequently, in step S78, in a case where the counter reaches a maximum value, set as a predetermined number of times that indicates that the state not being any of the known signals 0x47 and 0xB8 is repeated for a plurality of frames, the processing proceeds to step S80.

In step S80, the observation unit 123 notifies an observation result indicating the generation of any of the phase shift and spectrum inversion, to the signal compensation unit 121 as compensation information.

That is, when the state where the signal of eight bits in total, that is, the sum of the current input signal and the past seven-bit values is determined not to be any of the known signals 0x47 and 0xB8 is repeated continuously across a plurality of frames and the NG counter CNG exceeds the maximum value, an observation result indicating the generation of at least any of the phase shift and spectrum inversion is notified to the signal compensation unit 121 as compensation information. In short, when a known signal is not detected from the signal of the number of code-words corresponding to a plurality of frames, it is determined that at least any of the phase shift and spectrum inversion is generated.

Subsequently, by notifying the generation of at least any of the phase shift and spectrum inversion, the signal compensation unit 121, compensates, in step S51, for the I-signal and the Q-signal supplied from the demodulation processing unit 32.

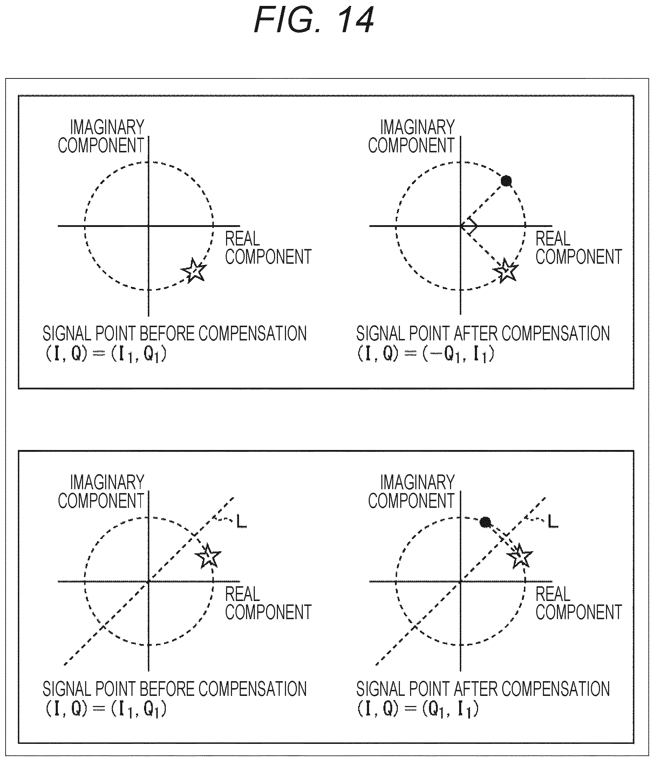

In a case, for example, where a 90-degree phase shift is compensated toward an input signal (I, Q) = (I1, Q1) indicated by the star on the complex plane illustrated in a left portion of the upper diagram in Fig. 14, the signal compensation unit 121 transforms the signal into an output signal (I, Q) = (-Q1, I1) indicated by the filled circle in a right portion of the upper diagram in Fig. 14, and outputs the transformed signal.

Moreover, in a case, for example, where spectrum inversion is compensated toward an input signal (I, Q) = (I1, Q1) indicated by the star on the complex plane illustrated in a left portion of the lower diagram in Fig. 14, the signal compensation unit 121 transforms the signal into an output signal (I, Q) = (Q1, I1) indicated by the filled circle in a right portion of the lower diagram in Fig. 14, and outputs the transformed signal. Herein, the line L in a lower diagram in Fig. 14 is a line satisfying I = Q.

Furthermore, in a case where the compensation information supplied from the observation unit 123 is an observation result indicating the generation of at least any of the phase shift and spectrum inversion, the signal compensation unit 121 sequentially switches the compensation for the phase shifts of 90, 180, and 270 degrees, and the compensation for the spectrum inversion. With this configuration, in addition to zero degree with no phase shift, compensation for the phase shifts of 90, 180, and 270 degrees, and compensation including the presence or absence of spectrum inversion, are sequentially switched. In addition, in a case where at least any of the phase shift and spectrum inversion is generated, compensation information indicating the generation of the phase shift and spectrum inversion is continuously supplied from the observation unit 123. Accordingly, compensation is repeated with sequentially switched content. Subsequently, the compensation information indicating the generation of the phase shift and spectrum inversion is no longer transmitted, compensation of the phase shift and spectrum inversion is stopped.

As a result, it is possible, in the Viterbi decoding unit 103, to achieve consistency between the input signal input from the likelihood transform unit 101 and the feedback signal supplied from the interleave processing unit 108 even when compensating for at least any of the phase shift and spectrum inversion is performed, and thus, to achieve error correction with higher accuracy.

Moreover, in order to correctly compensate, in the known arts, for the reception state where any of the phase shift and spectrum inversion is generated, there was a need to detect occurrence of a decoding failure from the error correction processing and to perform compensation. Therefore, the time needed for synchronization was a great factor to increase the time taken for error correction processing. In contrast, the reception device according to the present technology can perform compensation at a previous stage of Viterbi decoding processing, and thus, can reduce the time needed for synchronization.

Moreover, there was a need to provide a configuration that includes a separate error correction unit in parallel in order to reduce synchronization time needed for compensation for the phase shift and spectrum inversion. The present technology, however, does not need this configuration, and thus, can compensate for the phase shift and spectrum inversion without decreasing the mounting area.

### <Exemplary configuration of error correction unit to which present technology is applied, according to third embodiment>

The above section has described the case of compensating for the real components and imaginary components supplied from the demodulation processing unit 32, before being input into the likelihood transform unit 101, when compensation is performed for the phase shift and spectrum inversion. Alternatively, however, it is also allowable to perform compensation toward two types of likelihood, transformed by the likelihood transform unit 101.

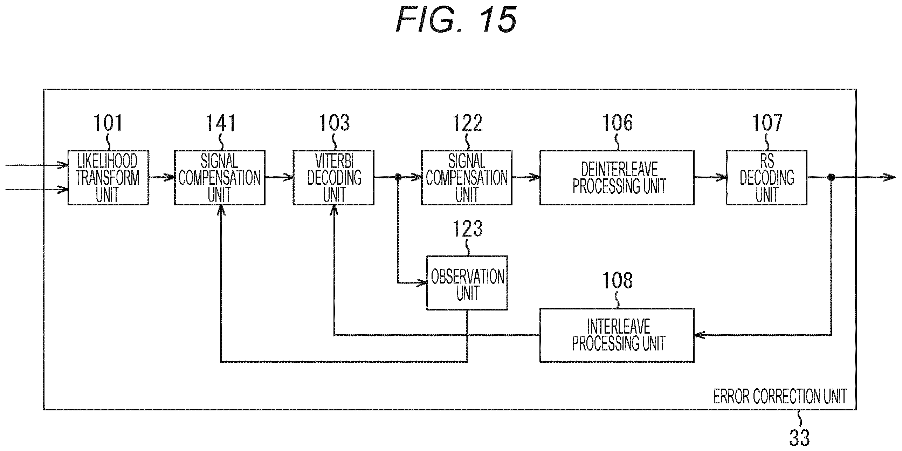

Fig. 15 is an exemplary configuration of the error correction unit 33 in which compensation is performed toward the two types of likelihood, transformed by the likelihood transform unit 101. Note that, in the exemplary configuration of the error correction unit 33 in Fig. 15, same names and reference signs are given to the configuration having functions same as the functions of the error correction unit 33 in Fig. 11, and description therefor will be omitted as appropriate.

Specifically, differences in the error correction unit 33 in Fig. 15 from the error correction unit 33 in Fig. 11 are that a signal compensation unit 141 is provided instead of the signal compensation unit 121, arranged in a post-stage of the likelihood transform unit 101 and in a pre-stage of the Viterbi decoding unit 103.

The signal compensation unit 141 performs compensation on two types of likelihood, namely, likelihood 1 and likelihood 2, supplied from the demodulation processing unit 32 by the likelihood transform unit 101 on the basis of compensation information supplied, as an observation result, from the observation unit 123.

### <Error correction processing by error correction unit in Fig. 15>

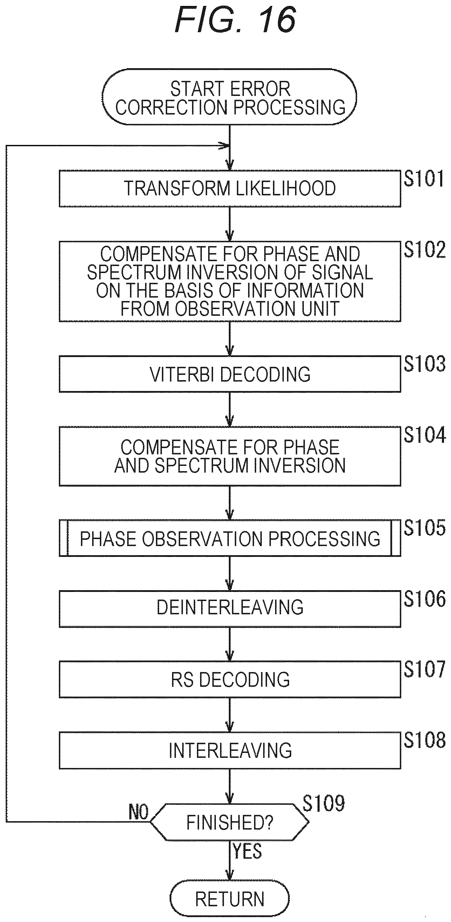

Next, error correction processing performed by the error correction unit 33 in Fig. 15 will be described with reference to the flowchart in Fig. 16. Note that processing in steps S101 and S103 to S109 in the flowchart in Fig. 16 is similar to the processing in steps S52 to S59 in the flowchart in Fig. 12, and accordingly, description therefor will be omitted.

Specifically, in the flowchart in Fig. 16, when the I-signal and the Q-signal are transformed, in step S101, into two types of likelihood 1 and likelihood 2 by the likelihood transform unit 101, the signal compensation unit 141 compensates, in step S102, for at least any of the phase shift and spectrum inversion with respect to likelihood 1 and likelihood 2 on the basis of compensation information as the observation result from the observation unit 123.

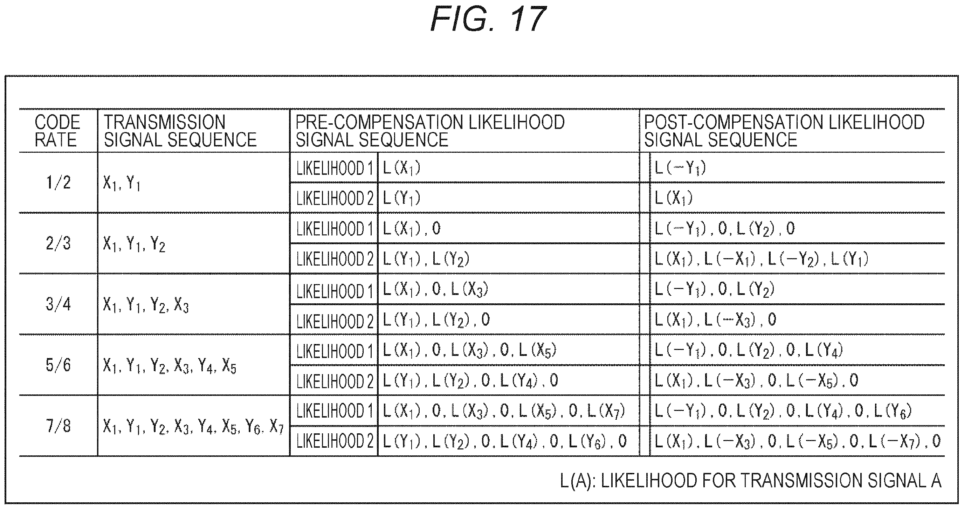

For example, likelihood transform processing of the likelihood transform unit 101 according to the DVB-S standard is classified into demodulation of QPSK modulation, and depuncturing. Accordingly, the signal compensation unit 141 performs compensation for the 90-degree shift, for example, as illustrated in Fig. 17.

Note that Fig. 17 illustrates, from the left side, examples of a code rate, a transmission signal sequence formed with the I-signal and Q-signal of the likelihood transform unit 101, pre-compensation likelihood signal sequence, and post-compensation likelihood signal sequence.

In a case where the code rate is 1/2, the likelihood transform unit 101 is assumed to transform a transmission signal sequence X1, Y1 into likelihood 1 = L(X1), likelihood 2 = L(Y1). In this case, the signal compensation unit 141 compensates for the likelihood 1 to L(-Y1) and compensates for the likelihood 2 to L(X1).

Moreover, in a case where the code rate is 2/3, the likelihood transform unit 101 is assumed to transform a transmission signal sequence X1, Y1, Y2 into likelihood 1 = L(X1), 0, and likelihood 2 = L(Y1), L(Y2). In this case, the signal compensation unit 141 compensates for the likelihood 1 to L(-Y1), 0, L(Y2), 0, and compensates for the likelihood 2 to L(X1), L(-X1), L(-Y2), L(Y1).

Furthermore, in a case where the code rate is 3/4, the likelihood transform unit 101 is assumed to transform a transmission signal sequence X1, Y1, Y2, X3 into likelihood 1 =L(X1), 0, L(X3), and the likelihood 2 =L(Y1), L(Y2), 0. In this case, the signal compensation unit 141 compensates for the likelihood 1 to L(-Y1), 0, L(Y2), and compensates for the likelihood 2 to L(X1), L(-X3), 0.

Moreover, in the case where the code rate is 5/6, the likelihood transform unit 101 is assumed to transform a transmission signal sequence X1, Y1, Y2, X3, Y4, X5 into likelihood 1 = L(X1), 0, L(X3), 0, L(X5), and likelihood 2 = L(Y1), L(Y2), 0, L(Y4), 0. In this case, the signal compensation unit 141 compensates for the likelihood 1 to L(-Y1), 0, L(Y2), 0, L(Y4), and compensates for the likelihood 2 to L(X1), L(-X3), 0, L(X5), 0.

Furthermore, in a case where the code rate is 7/8, the likelihood transform unit 101 is assumed to transform a transmission signal sequence X1, Y1, Y2, X3, Y4, X5, Y6, X7 into likelihood 1 = L(X1), 0, L(X3), 0, L(X5), 0, L(X7), and likelihood 2 = L(Y1), L(Y2), 0, L(Y4), 0, L(Y6), 0. In this case, the signal compensation unit 141 compensates for the likelihood 1 to L(-Y1), 0, L(Y2), 0, L(Y4), 0, L(Y6), and compensates for the likelihood 2 to L(X1), L(-X3), 0, L(X5), 0, L(-X7), 0.

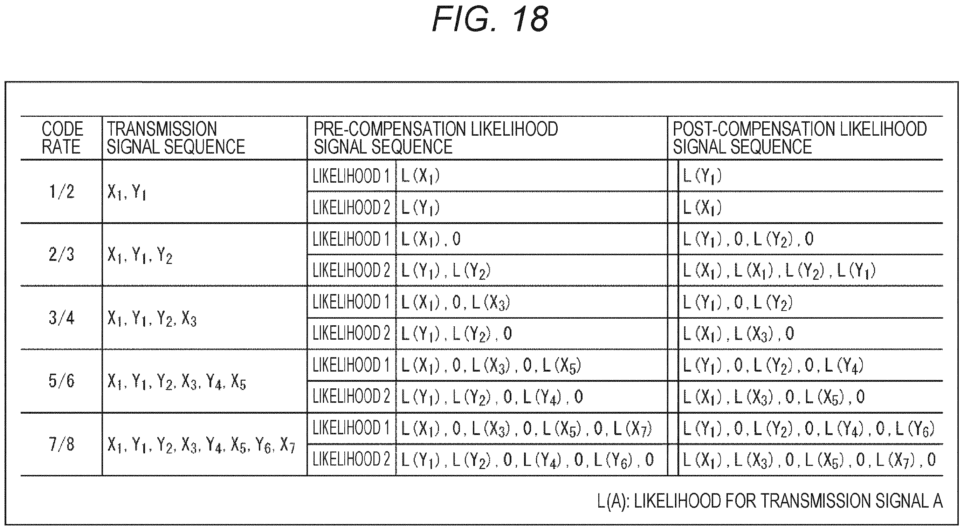

Moreover, the signal compensation unit 141 performs compensation for spectrum inversion as illustrated in Fig. 18.

Note that Fig. 18 illustrates, from the left side, examples of a code rate, a transmission signal sequence formed with the I-signal and Q-signal of the likelihood transform unit 101, a pre-compensation likelihood signal sequence, and a post-compensation likelihood signal sequence.

In a case where the code rate is 1/2, the likelihood transform unit 101 is assumed to transform a transmission signal sequence X1, Y1 into likelihood 1 = L(X1), likelihood 2 = L(Y1). In this case, the signal compensation unit 141 compensates for the likelihood 1 to L(Y1) and compensates for the likelihood 2 to L(X1).

Moreover, in a case where the code rate is 2/3, the likelihood transform unit 101 is assumed to transform a transmission signal sequence X1, Y1, Y2 into likelihood 1 = L(X1), 0, and likelihood 2 = L(Y1), L(Y2). In this case, the signal compensation unit 141 compensates the likelihood 1 to L(Y1), 0, L(Y2), 0, and compensates the likelihood 2 to L(X1), L(X1), L(Y2), L(Y1).

Furthermore, in a case where the code rate is 3/4, the likelihood transform unit 101 is assumed to transform a transmission signal sequence X1, Y1, Y2, X3 into likelihood 1 =L(X1), 0, L(X3), and the likelihood 2 =L(Y1), L(Y2), 0. In this case, the signal compensation unit 141 compensates for the likelihood 1 to L(Y1), 0, L(Y2), and compensates the likelihood 2 to L(X1), L(X3), 0.

Moreover, in the case where the code rate is 5/6, the likelihood transform unit 101 is assumed to transform a transmission signal sequence X1, Y1, Y2, X3, Y4, X5 into likelihood 1 = L(X1), 0, L(X3), 0, L(X5), and likelihood 2 = L(Y1), L(Y2), 0, L(Y4), 0. In this case, the signal compensation unit 141 compensates for the likelihood 1 to L(Y1), 0, L(Y2), 0, L(Y4), and compensates for the likelihood 2 to L(X1), L(X3), 0, L(X5), 0.

Furthermore, in a case where the code rate is 7/8, the likelihood transform unit 101 is assumed to transform a transmission signal sequence X1, Y1, Y2, X3, Y4, X5, Y6, X7 into likelihood 1 = L(X1), 0, L(X3), 0, L(X5), 0, L(X7), and likelihood 2 = L(Y1), L(Y2), 0, L(Y4), 0, L(Y6), 0. In this case, the signal compensation unit 141 compensates for the likelihood 1 to L(Y1), 0, L(Y2), 0, L(Y4), 0, L(Y6), and compensates for the likelihood 2 to L(X1), L(X3), 0, L(X5), 0, L(X7), 0.

As a result, it is possible, in the Viterbi decoding unit 103, to achieve consistency between the input signal input from the likelihood transform unit 101 and the feedback signal supplied from the interleave processing unit 108 by compensating for at least any of the phase shift and spectrum inversion, and thus, to achieve error correction with higher accuracy.

### <Exemplary configuration of error correction unit to which present technology is applied, according to fourth embodiment>

While the above-described section individually described an exemplary case where frame position shift is compensated by the configuration of the error correction unit 33 according to the first embodiment, and an exemplary case where phase shift and spectrum inversion are compensated by an exemplary configuration according to the third embodiment, it is also allowable to combine these.

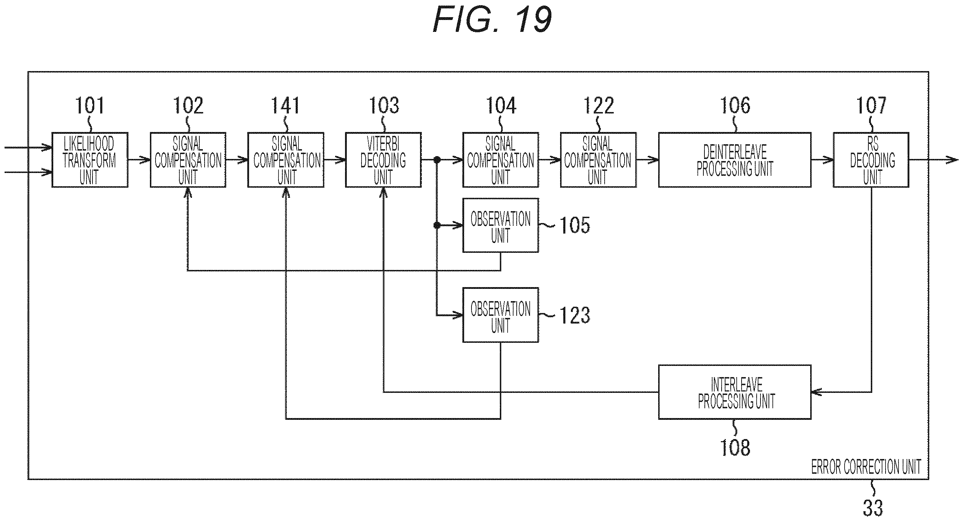

Fig. 19 is an exemplary configuration of the error correction unit 33 configured to compensate for the frame position shift on the input signal and to compensate for the phase shift and spectrum inversion. Note that, in the configuration of the error correction unit 33 in Fig. 19, same names and reference signs are given to the configuration having functions same as the functions of the error correction unit 33 n Figs. 4, 11, and 15 and description therefor will be omitted as appropriate.

Specifically, differences in the configuration of the error correction unit 33 in Fig. 19 from the configuration of the error correction unit 33 in Fig. 15 are that the signal compensation unit 102 is provided in a pre-stage of the signal compensation unit 141, the observation unit 105 is provided in parallel with the observation unit 123, and furthermore, the signal compensation unit 104 is provided in a pre-stage of the signal compensation unit 122.

With this configuration, frame position shift is observed by the observation unit 105, and compensation information corresponding to the observation result is supplied to the signal compensation unit 102. Moreover, presence or absence of at least any of the phase shift and spectrum inversion is observed by the observation unit 123, and compensation information corresponding to the observation result is supplied to the signal compensation unit 141. Subsequently, the signal Viterbi-decoded by the Viterbi decoding unit 103 has its frame position shift compensated by the signal compensation unit 104, and thereafter, has its phase shift and spectrum inversion compensated by the signal compensation unit 122.

With this configuration, the Viterbi decoding unit 103 can achieve Viterbi decoding by using the feedback signal having consistency with the input signal, regarding the frame position shift, the phase shift, and spectrum inversion.

As a result, it is possible to achieve error correction with high accuracy.

### <Error correction processing by error correction unit in Fig. 19>

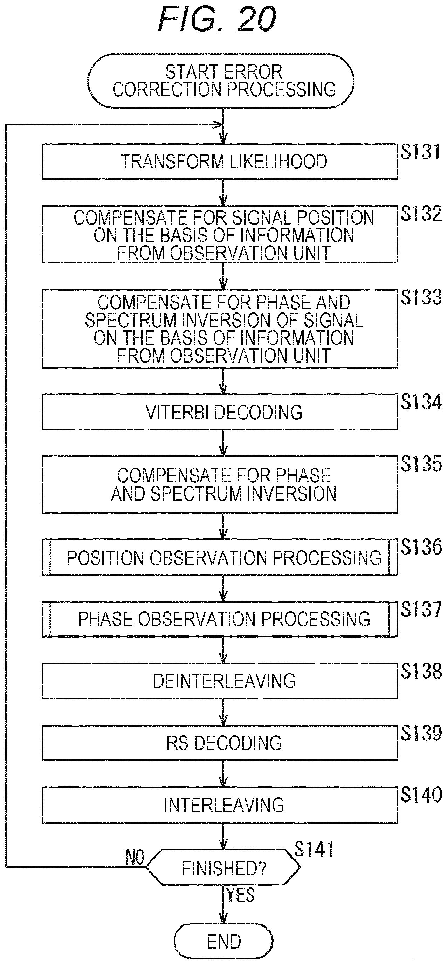

Next, error correction processing performed by the error correction unit 33 in Fig. 19 will be described with reference to the flowchart in Fig. 20. Note that steps S131, S132, S134 to S136, and S138 to S141 in the flowchart in Fig. 20 are similar to the processing in steps S11 to S19 in Fig. 6. Moreover, processing in steps S133 and S137 is similar to the processing in steps S102 and S105 in the flowchart in Fig. 16.

Specifically, frame position shift of the input signal is compensated in accordance with the compensation information as observation result obtained by the observation unit 105, by the error correction processing performed by the error correction unit 33 in Fig. 19, and thereafter, any of the phase shift and spectrum inversion is compensated by the compensation information as the observation result obtained by the observation unit 123. With this configuration, the feedback signal that has undergone compensation of the position shift in units of frames (units of code-words) and compensation for the phase shift and spectrum inversion is input into the Viterbi decoding unit 103, and the input signal that has undergone compensation and that has consistency with the feedback signal is going to be input into the Viterbi decoding unit 103. Accordingly, the Viterbi decoding unit 103 can achieve Viterbi decoding for the input signal by using the feedback signal having consistency with the input signal, that has undergone compensation of the frame position shift, the phase shift, and spectrum inversion.

Note that, while in the above description, compensation processing for the position shift is provided in a pre-stage of the compensation processing for the phase shift and spectrum inversion, it is also allowable to exchange the sequential relationship between the compensation processing for the phase shift and the compensation processing for the spectrum inversion.

As a result, as described above, it is possible to achieve error correction with higher accuracy even in a case of using repetition processing in error correction processing.

### <Exemplary case of execution by software>

Meanwhile, a series of processing described above can be executed either in hardware or by software. In a case where the series of processing is executed by software, a program constituting the software is installed from a recording medium onto a computer incorporated in dedicated hardware, or onto a general-purpose computer, for example, capable of executing various functions by installing various programs.

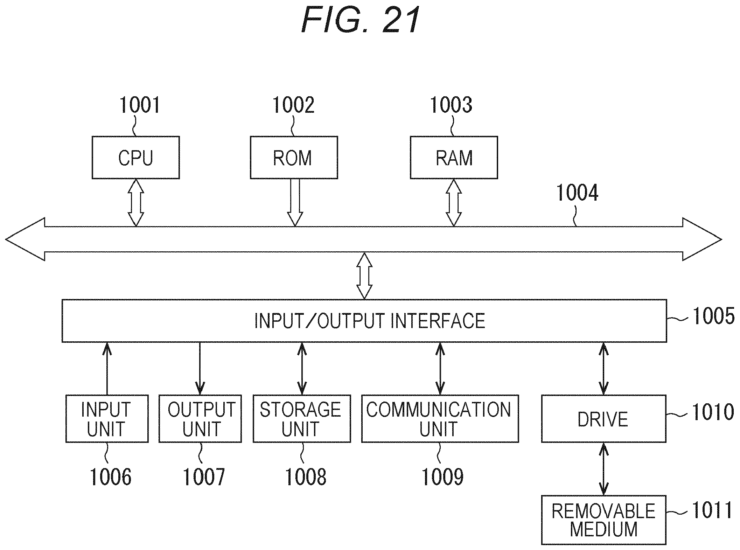

Fig. 21 illustrates an exemplary configuration of a general-purpose personal computer. This personal computer incorporates a central processing unit (CPU) 1001. An input/output interface 1005 is coupled with the CPU 1001 via a bus 1004. A read only memory (ROM) 1002 and a random access memory (RAM) 1003 are coupled to the bus 1004.

The input/output interface 1005 is connected with an input unit 1006, an output unit 1007, a storage unit 1008, and a communication unit 1009. The input unit 1006 includes input devices such as a keyboard and a mouse used by a user to input operation commands. The output unit 1007 outputs a processing operation screen and a processing result image onto a display device. The storage unit 1008 includes a hardware drive for storing programs and various data. The communication unit 1009 includes a local area network (LAN) adapter and executes communication processing via a network represented by the Internet. Moreover, connection is made with a drive 1010 for reading and writing data toward a removable medium 1011 such as a magnetic disk (including a flexible disk), an optical disc (including a compact disc-read only memory (CD-ROM) and a digital versatile disc (DVD)), a magneto optical disc (including a mini disc (MD)), or a semiconductor memory.

The CPU 1001 executes various types of processing in accordance with a program stored in the ROM 1002 or a program that is read from the removable medium 1011 such as the magnetic disk, the optical disc, the magneto optical disc, or the semiconductor memory, installed in the storage unit 1008, and loaded from the storage unit 1008 to the RAM 1003. The RAM 1003 also stores data, or the like, appropriately, that are needed when the CPU 1001 executes various types of processing.

On the computer configured as above, the series of above-described processing is executed by operation such that the CPU 1001 loads, for example, a program stored in the storage unit 1008 onto the RAM 1003 via the input/output interface 1005 and the bus 1004 and executes the program.

The program executed by the computer (CPU 1001) can be stored, for example, in the removable medium 1011 as a package medium and be provided. Alternatively, the program can be provided via a wired or wireless transmission medium including a local area network, the Internet, and digital satellite broadcasting.

On the computer, the program can be installed in the storage unit 1008 via the input/output interface 1005, by attaching the removable medium 1011 to the drive 1010. In this case, the program can be received at the communication unit 1009 via a wired or wireless transmission medium and be installed in the storage unit 1008. Alternatively, the program can be installed in the ROM 1002 or the storage unit 1008 beforehand.

Note that the program executed by the computer may be a program processed in a time series in an order described in the present description, or can be a program processed in required timing such as being called.

Moreover, in the present description, the system represents a set of multiple constituents (devices, modules (parts), or the like). In other words, all the constituents may be in a same housing but they do not have to be in the same housing. Accordingly, a plurality of devices, housed in separate housings, connected via a network can be a system. A device in which a plurality of modules is housed in one housing can also be a system.

Note that embodiments of the present technology are not limited to the above-described embodiments but can be modified in a variety of ways within a scope of the present technology.

For example, the present technology can be configured as a form of cloud computing in which one function is shared in cooperation for processing among a plurality of devices via a network.

Moreover, each of steps described in the above flowcharts can be executed on one device or shared by a plurality of devices for processing.

Furthermore, when one step includes a plurality of stages of processing, the plurality of stages of processing included in the one step can be executed on one device or can be shared by a plurality of devices.

### REFERENCE SIGNS LIST

- 11: reception device
- 31: antenna
- 32: demodulation processing unit
- 33: error correction unit
- 34: decoder
- 35: output unit
- 51: likelihood transform unit
- 52: Viterbi decoding unit
- 53: signal compensation unit
- 54: deinterleave processing unit
- 55: Read-Solomon (RS) decoding unit
- 57: interleave processing unit
- 101: likelihood transform unit
- 102: signal compensation unit
- 103: Viterbi decoding unit
- 104: signal compensation unit
- 105: observation unit
- 106: deinterleave processing unit
- 107: RS decoding unit
- 109: interleave processing unit
- 121: signal compensation unit
- 122: signal compensation unit
- 123: observation unit
- 141: signal compensation unit

## Claims

1. A reception device (11) comprising:
a demodulation unit (32) configured to perform demodulation processing on a signal received by an antenna and output a demodulated signal;
a first decoding unit (103) configured to decode the demodulated signal to a first decoded signal;
a first observation unit (105) configured to observe a known signal included in the first decoded signal and output corresponding compensation information;
a first signal compensation unit (104) configured to compensate for the first decoded signal on the basis of the known signal included in the first decoded signal;
a second decoding unit (107) configured to decode the first decoded signal that is compensated by the first signal compensation unit (104) and subsequently deinterleaved by a deinterleave processing unit (106), to a second decoded signal;
an interleave processing unit (108) configured to perform interleave processing on the second decoded signal and to output a feedback signal to the first decoding unit (103); and
a second signal compensation unit (102) arranged in a pre-stage of the first decoding unit (103) and configured to compensate for the demodulated signal on the basis of the compensation information from the first observation unit (105),
wherein the first decoding unit (103) decodes the demodulated signal compensated by the second signal compensation unit (102), to the first decoded signal using the feedback signal output by the interleave processing unit (108),
the first signal compensation unit (104) estimates a phase shift and spectrum inversion of the signal on the basis of the known signal included in the first decoded signal and then compensates for the phase shift and spectrum inversion of the first decoded signal,
the first observation unit (105) observes the known signal included in the first decoded signal, estimates the phase shift and spectrum inversion of the signal, and then, outputs the corresponding compensation information, and
the second signal compensation unit compensates for the phase shift and spectrum inversion of the first decoded signal of the demodulated signal on the basis of the compensation information from the first observation unit (105).

2. The reception device according to claim 1 further comprising:
a likelihood transform unit (101) configured to transform the demodulated signal into likelihood,
wherein the second signal compensation unit (121) is arranged in a pre-stage of the likelihood transform unit (101) and the first decoding unit (103) and compensates for the phase shift and spectrum inversion of the first decoded signal of the demodulated signal, on the basis of the compensation information from the first observation unit (123).

3. The reception device according to claim 1 further comprising:
a likelihood transform unit (101) configured to transform the demodulated signal into likelihood,
wherein the second signal compensation unit (141) is arranged in a post-stage of the likelihood transform unit (101) and in a pre-stage of the first decoding unit (103) and compensates for the phase shift and spectrum inversion of the first decoded signal of the likelihood obtained by transforming the demodulated signal, on the basis of the compensation information from the first observation unit (105).

4. The reception device according to claim 3 further comprising:
a third signal compensation unit (122) configured, on the basis of the known signal included in the first decoded signal, to estimate a frame configuration of the signal, and to compensate for the first decoded signal;
a second observation unit (123) configured to observe the known signal included in the first decoded signal, estimate a frame configuration of the signal, and output corresponding compensation information; and
a fourth signal compensation unit (141) arranged in a pre-stage of the first decoding unit and configured to compensate for the demodulated signal on the basis of the compensation information as an observation result of the second observation unit.

5. The reception device according to claim 4,
wherein the third signal compensation unit (122) is arranged in a pre-stage of the first signal compensation unit and compensates for the first decoded signal, and
the fourth signal compensation unit (141) is arranged in a pre-stage of the second signal compensation unit and compensates for the demodulated signal.

6. The reception device according to claim 4,
wherein the third signal compensation unit (122) is arranged in a post-stage of the first signal compensation unit and compensates for the first decoded signal, and
the fourth signal compensation unit is arranged in a post-stage of the second signal compensation unit and compensates for the demodulated signal.

7. The reception device according to claim 1,
wherein the first decoding unit (103) decodes the demodulated signal into the first decoded signal by Viterbi decoding.

8. The reception device according to claim 1,
wherein the second decoding unit (107) decodes the first decoded signal compensated by the first signal compensation unit (104) to the second decoded signal, using Read-Solomon (RS) decoding.

9. A receiving method on a reception device, the method comprising:
performing demodulation processing on a signal received by an antenna and outputting a demodulated signal;
decoding (S13) the demodulated signal to a first decoded signal by a first decoding unit;
observing a known signal included in the first decoded signal and outputting corresponding compensation information by a first observation unit;
compensating (S14) for the first decoded signal on the basis of the known signal included in the first decoded signal by a first signal compensation unit;
decoding (S17) the first decoded signal that is compensated by the first signal compensation unit and subsequently is deinterleaved by a deinterleave processing unit to a second decoded signal by a second decoding unit;
performing interleave processing (S18) on the second decoded signal and outputting a feedback signal to the first decoding unit; and
compensating (S12) for the demodulated signal by a second signal compensation unit arranged in a pre-stage of the first decoding unit on the basis of the compensation information from the first observation unit,
wherein decoding the first decoded signal comprises decoding the demodulated signal compensated by the second signal compensation unit, to the first decoded signal using the feedback signal,
compensating for a phase shift and spectrum inversion of the first decoded signal by the first signal compensating unit comprises estimating the phase shift and spectrum inversion of the signal on the basis of the known signal included in the first decoded signal and then compensating for the phase shift and spectrum inversion of the first decoded signal,
outputting the compensation information by the first observation unit comprises estimating the phase shift and spectrum inversion of the first decoded signal, and then outputting the corresponding compensation information, and
compensating for the phase shift and spectrum inversion of the first decoded signal by the second compensation unit comprises compensating for the phase shift and spectrum inversion of the first decoded signal of the demodulated signal on the basis of the compensation information from the first observation unit.

10. A computer program comprising instructions, which when executed on a computer, cause the computer to carry out the method of claim 9.

## Patentansprüche

1. Empfangsvorrichtung (11), die Folgendes umfasst:
eine Demodulationseinheit (32), die dazu ausgelegt ist, Demodulationsverarbeitung an einem durch eine Antenne empfangenen Signal durchzuführen und ein demoduliertes Signal auszugeben;
eine erste Decodierungseinheit (103), die dazu ausgelegt ist, das demodulierte Signal zu einem ersten decodierten Signal zu decodieren;
eine erste Beobachtungseinheit (105), die dazu ausgelegt ist, ein in dem ersten decodierten Signal enthaltenes bekanntes Signal zu beobachten und entsprechende Kompensationsinformationen auszugeben;
eine erste Signalkompensationseinheit (104), die dazu ausgelegt ist, das erste decodierte Signal auf der Basis des in dem ersten decodierten Signal enthaltenen bekannten Signals zu kompensieren;
eine zweite Decodierungseinheit (107), die dazu ausgelegt ist, das erste decodierte Signal, das durch die erste Signalkompensationseinheit (104) kompensiert und anschließend durch eine Entschachtelungs-Verarbeitungseinheit (106) entschachtelt wird, zu einem zweiten decodierten Signal zu decodieren;
eine Verschachtelungs-Verarbeitungseinheit (108), die dazu ausgelegt ist, Verschachtelungsverarbeitung an dem zweiten decodierten Signal durchzuführen und ein Rückkopplungssignal an die erste Decodierungseinheit (103) auszugeben; und
eine zweite Signalkompensationseinheit (102), die in einer Vorstufe der ersten Decodierungseinheit (103) angeordnet und dazu ausgelegt ist, das demodulierte Signal auf der Basis der Kompensationsinformationen von der ersten Beobachtungseinheit (105) zu kompensieren,
wobei die erste Decodierungseinheit (103) das demodulierte Signal, das durch die zweite Signalkompensationseinheit (102) kompensiert wurde, unter Verwendung des von der Verschachtelungs-Verarbeitungseinheit (108) ausgegebenen Rückkopplungssignals zu dem ersten decodierten Signal decodiert,
die erste Signalkompensationseinheit (104) eine Phasenverschiebung und Spektruminversion des Signals auf der Basis des in dem ersten decodierten Signal enthaltenen bekannten Signals abschätzt, und dann die Phasenverschiebung und Spektruminversion des ersten decodierten Signals kompensiert,
die erste Beobachtungseinheit (105) das in dem ersten decodierten Signal enthaltene bekannte Signal beobachtet, die Phasenverschiebung und Spektruminversion des Signals abschätzt, und dann die entsprechenden Kompensationsinformationen ausgibt, und
die zweite Signalkompensationseinheit die Phasenverschiebung und Spektruminversion des ersten decodierten Signals des demodulierten Signals auf der Basis der Kompensationsinformationen von der ersten Beobachtungseinheit (105) kompensiert.

2. Empfangsvorrichtung gemäß Anspruch 1, die ferner Folgendes umfasst:
eine Likelihood-Umwandlungseinheit (101), die dazu ausgelegt ist, das demodulierte Signal in eine Likelihood umzuwandeln,
wobei die zweite Signalkompensationseinheit (121) in einer Vorstufe der Likelihood-Umwandlungseinheit (101) und der ersten Decodierungseinheit (103) angeordnet ist und die Phasenverschiebung und Spektruminversion des ersten decodierten Signals des demodulierten Signals auf der Basis der Kompensationsinformationen von der ersten Beobachtungseinheit (123) kompensiert.

3. Empfangsvorrichtung gemäß Anspruch 1, die ferner Folgendes umfasst:
eine Likelihood-Umwandlungseinheit (101), die dazu ausgelegt ist, das demodulierte Signal in eine Likelihood umzuwandeln,
wobei die zweite Signalkompensationseinheit (141) in einer Nachstufe der Likelihood-Umwandlungseinheit (101) und in einer Vorstufe der ersten Decodierungseinheit (103) angeordnet ist und die Phasenverschiebung und Spektruminversion des ersten decodierten Signals der durch Umwandeln des demodulierten Signals erhaltenen Likelihood auf der Basis der Kompensationsinformationen von der ersten Beobachtungseinheit (105) kompensiert.

4. Empfangsvorrichtung gemäß Anspruch 3, die ferner Folgendes umfasst:
eine dritte Signalkompensationseinheit (122), die dazu ausgelegt ist, auf der Basis des in dem ersten decodierten Signal enthaltenen bekannten Signals, eine Rahmenkonfiguration des Signals abzuschätzen und das erste decodierte Signal zu kompensieren;
eine zweite Beobachtungseinheit (123), die dazu ausgelegt ist, das in dem ersten decodierten Signal enthaltene bekannte Signal zu beobachten, eine Rahmenkonfiguration des Signals abzuschätzen, und entsprechende Kompensationsinformationen auszugeben; und
eine vierte Signalkompensationseinheit (141), die in einer Vorstufe der ersten Decodierungseinheit angeordnet und dazu ausgelegt ist, das demodulierte Signal auf der Basis der Kompensationsinformationen als ein Beobachtungsergebnis der zweiten Beobachtungseinheit zu kompensieren.

5. Empfangsvorrichtung gemäß Anspruch 4,
wobei die dritte Signalkompensationseinheit (122) in einer Vorstufe der ersten Signalkompensationseinheit angeordnet ist und das erste decodierte Signal kompensiert, und
die vierte Signalkompensationseinheit (141) in einer Vorstufe der zweiten Signalkompensationseinheit angeordnet ist und das demodulierte Signal kompensiert.

6. Empfangsvorrichtung gemäß Anspruch 4,
wobei die dritte Signalkompensationseinheit (122) in einer Nachstufe der ersten Signalkompensationseinheit angeordnet ist und das erste decodierte Signal kompensiert, und
die vierte Signalkompensationseinheit in einer Nachstufe der zweiten Signalkompensationseinheit angeordnet ist und das demodulierte Signal kompensiert.

7. Empfangsvorrichtung gemäß Anspruch 1,
wobei die erste Decodierungseinheit (103) das demodulierte Signal durch Viterbi-Decodierung zu dem ersten decodierten Signal decodiert.

8. Empfangsvorrichtung gemäß Anspruch 1,
wobei die zweite Decodierungseinheit (107) das erste decodierte Signal, das durch die erste Signalkompensationseinheit (104) kompensiert wurde, unter Verwendung von Reed-Solomon(RS)-Decodierung zu dem zweiten decodierten Signal decodiert.

9. Empfangsverfahren an einer Empfangsvorrichtung, wobei das Verfahren Folgendes umfasst:
Durchführen von Demodulationsverarbeitung an einem durch eine Antenne empfangenen Signal, und Ausgeben eines demodulierten Signals;
Decodieren (S13) des demodulierten Signals durch eine erste Decodierungseinheit zu einem ersten decodierten Signal;
Beobachten eines in dem ersten decodierten Signal enthaltenen bekannten Signals, und Ausgeben von entsprechenden Kompensationsinformationen durch eine erste Beobachtungseinheit;
Kompensieren (S14) des ersten decodierten Signals auf der Basis des in dem ersten decodierten Signal enthaltenen bekannten Signals durch eine erste Signalkompensationseinheit;
Decodieren (S17) des ersten decodierten Signals, das durch die erste Signalkompensationseinheit kompensiert und anschließend durch eine Entschachtelungs-Verarbeitungseinheit entschachtelt wird, durch eine zweite Decodierungseinheit zu einem zweiten decodierten Signal;
Durchführen von Verschachtelungsverarbeitung (S18) an dem zweiten decodierten Signal, und Ausgeben eines Rückkopplungssignals an die erste Decodierungseinheit; und
Kompensieren (S12) des demodulierten Signals durch eine zweite Signalkompensationseinheit, die in einer Vorstufe der ersten Decodierungseinheit angeordnet ist, auf der Basis der Kompensationsinformationen von der ersten Beobachtungseinheit,
wobei das Decodieren des ersten decodierten Signals das Decodieren des demodulierten Signals, das durch die zweite Signalkompensationseinheit kompensiert wurde, zu dem ersten decodierten Signal unter Verwendung des Rückkopplungssignals umfasst,
das Kompensieren einer Phasenverschiebung und Spektruminversion des ersten decodierten Signals durch die erste Signalkompensationseinheit das Abschätzen der Phasenverschiebung und Spektruminversion des Signals auf der Basis des in dem ersten decodierten Signal enthaltenen bekannten Signals, und anschließend Kompensieren der Phasenverschiebung und Spektruminversion des ersten decodierten Signals umfasst,
das Ausgeben der Kompensationsinformationen durch die erste Beobachtungseinheit das Abschätzen der Phasenverschiebung und Spektruminversion des ersten decodierten Signals, und anschließend Ausgeben der entsprechenden Kompensationsinformationen umfasst, und
das Kompensieren der Phasenverschiebung und Spektruminversion des ersten decodierten Signals durch die zweite Kompensationseinheit das Kompensieren der Phasenverschiebung und Spektruminversion des ersten decodierten Signals des demodulierten Signals auf der Basis der Kompensationsinformationen von der ersten Beobachtungseinheit umfasst.

10. Computerprogramm, das Befehle aufweist, die, wenn sie auf einem Computer ausgeführt werden, den Computer veranlassen, das Verfahren nach Anspruch 9 auszuführen.

## Revendications

1. Dispositif de réception (11) comprenant :
une unité de démodulation (32) configurée pour effectuer un traitement de démodulation sur un signal reçu par une antenne et pour émettre un signal démodulé ;
une première unité de décodage (103) configurée pour décoder le signal démodulé en un premier signal décodé ;
une première unité d'observation (105) configurée pour observer un signal connu inclus dans le premier signal décodé et pour transmettre des informations de compensation correspondantes ;
une première unité de compensation de signal (104) configurée pour compenser le premier signal décodé sur la base du signal connu inclus dans le premier signal décodé ;
une seconde unité de décodage (107) configurée pour décoder le premier signal décodé qui est compensé par la première unité de compensation de signal (104) et, par la suite, désentrelacé par une unité de traitement de désentrelacement (106), en un second signal décodé ;
une unité de traitement d'entrelacement (108) configurée pour effectuer un traitement d'entrelacement sur le second signal décodé et pour émettre un signal de rétroaction vers la première unité de décodage (103) ; et
une deuxième unité de compensation de signal (102) agencée à un pré-étage de la première unité de décodage (103) et configurée pour compenser le signal démodulé sur la base des informations de compensation provenant de la première unité de compensation (105),
dans lequel la première unité de décodage (103) décode le signal démodulé compensé par la deuxième unité de compensation de signal (102) en un premier signal décodé à l'aide du signal de rétroaction émis par l'unité de traitement d'entrelacement (108),
la première unité de compensation de signal (104) estime un déphasage et une inversion de spectre du signal sur la base du signal connu inclus dans le premier signal décodé et, ensuite, compense le déphasage et l'inversion de spectre du premier signal décodé,
la première unité d'observation (105) observe le signal connu inclus dans le premier signal décodé, estime le déphasage et l'inversion de spectre du signal et, ensuite, transmet les informations de compensation correspondantes et
la deuxième unité de compensation de signal compense le déphasage et l'inversion de spectre du premier signal décodé du signal démodulé sur la base des informations de compensation provenant de la première unité d'observation (105) .

2. Dispositif de réception selon la revendication 1, comprenant en outre :
une unité de transformation en probabilité (101) configurée pour transformer le signal démodulé en probabilité,
dans lequel la deuxième unité de compensation de signal (121) est agencée à un pré-étage de l'unité de transformation en probabilité (101) et de la première unité de décodage (103) et compense le déphasage et l'inversion de spectre du premier signal décodé du signal démodulé sur la base des informations de compensation provenant de la première unité d'observation (123).

3. Dispositif de réception selon la revendication 1, comprenant en outre :
une unité de transformation en probabilité (101) configurée pour transformer le signal démodulé en probabilité,
dans lequel la deuxième unité de compensation de signal (141) est agencée à un post-étage de l'unité de transformation en probabilité (101) et à un pré-étage de la première unité de décodage (103) et compense le déphasage et l'inversion de spectre du premier signal décodé de la probabilité obtenue en transformant le signal démodulé sur la base des informations de compensation provenant de la première unité d'observation (105).

4. Dispositif de réception selon la revendication 3, comprenant en outre :
une troisième unité de compensation de signal (122) configurée, sur la base du signal connu inclus dans le premier signal décodé, pour estimer une configuration de trame du signal et pour compenser le premier signal décodé ;
une seconde unité d'observation (123) configurée pour observer le signal connu inclus dans le premier signal décodé, pour estimer une configuration de trame du signal et pour transmettre des informations de compensation correspondantes ; et
une quatrième unité de compensation de signal (141) agencée à un pré-étage de la première unité de décodage et configurée pour compenser le signal démodulé sur la base des informations de compensation en tant que résultat d'observation de la seconde unité d'observation.

5. Dispositif de réception selon la revendication 4,
dans lequel la troisième unité de compensation de signal (122) est agencée à un pré-étage de la première unité de compensation de signal et compense le premier signal décodé ; et
la quatrième unité de compensation de signal (141) est agencée à un pré-étage de la deuxième unité de compensation de signal et compense le signal démodulé.

6. Dispositif de réception selon la revendication 4,
dans lequel la troisième unité de compensation de signal (122) est agencée à un post-étage de la première unité de compensation de signal et compense le premier signal décodé ; et
la quatrième unité de compensation de signal est agencée à un post-étage de la deuxième unité de compensation de signal et compense le signal démodulé.

7. Dispositif de réception selon la revendication 1,
dans lequel la première unité de décodage (103) décode le signal démodulé en le premier signal décodé par un décodage de Viterbi.

8. Dispositif de réception selon la revendication 1,
dans lequel la seconde unité de décodage (107) décode le premier signal décodé compensé par la première unité de compensation de signal (104) en le second signal décodé à l'aide d'un décodage de Read-Solomon (RS).

9. Procédé de réception sur un dispositif de réception, le procédé consistant :
à effectuer un traitement de démodulation sur un signal reçu par une antenne et à émettre un signal démodulé ;
à décoder (S13) le signal démodulé en un premier signal décodé au moyen d'une première unité de décodage ;
à observer un signal connu inclus dans le premier signal décodé et à transmettre des informations de compensation correspondantes au moyen d'une première unité d'observation ;
à compenser (S14) le premier signal décodé sur la base du signal connu inclus dans le premier signal décodé au moyen d'une première unité de compensation de signal ;
à décoder (S17) le premier signal décodé qui est compensé par la première unité de compensation de signal et qui est, par la suite, désentrelacé par une unité de traitement de désentrelacement, en un second signal décodé au moyen d'une seconde unité de décodage ;
à effectuer un traitement d'entrelacement (S18) sur le second signal décodé et à émettre un signal de rétroaction vers la première unité de décodage ; et
à compenser (S12) le signal démodulé au moyen d'une deuxième unité de compensation de signal agencée à un pré-étage de la première unité de décodage sur la base des informations de compensation provenant de la première unité de compensation,
dans lequel le décodage du premier signal décodé consiste à décoder le signal démodulé compensé par la deuxième unité de compensation de signal en un premier signal décodé à l'aide du signal de rétroaction,
la compensation d'un déphasage et d'une inversion de spectre du premier signal décodé au moyen de la première unité de compensation de signal consiste à estimer le déphasage et l'inversion de spectre du signal sur la base du signal connu inclus dans le premier signal décodé et, ensuite, à compenser le déphasage et l'inversion de spectre du premier signal décodé,
la transmission des informations de compensation correspondantes au moyen de la première unité d'observation consiste à estimer le déphasage et l'inversion de spectre du premier signal décodé et, ensuite, à transmettre les informations de compensation correspondantes, et
la compensation du déphasage et de l'inversion de spectre du premier signal décodé au moyen de la deuxième unité de compensation consiste à compenser le déphasage et l'inversion de spectre du premier signal décodé du signal démodulé sur la base des informations de compensation provenant de la première unité d'observation.

10. Programme d'ordinateur comprenant des instructions qui, lorsqu'elles sont exécutées sur un ordinateur, contraignent l'ordinateur à réaliser le procédé selon la revendication 9.
